# EUROPEAN PATENT APPLICATION

(11) **EP 4 376 083 A1**
(43) Date of publication of application: **29.05.2024**
(21) Application number: 23194197.2
(22) Date of filing: 30.08.2023
(51) Int. Cl.: H01L 27/146

(54) **IMAGE SENSOR**

(30) Priority: 28.11.2022 KR 20220161994
(71) Applicant: Samsung Electronics Co., Ltd., Suwon-si, Gyeonggi-do 16677 (KR)
(72) Inventor: GO, Jonghyun, 16677 Suwon-si (KR)
(74) Representative: Marks & Clerk LLP

(57) **Abstract**

An image sensor includes a substrate including an active region with source and drain regions, a source follower gate pattern on the active region, the drain and source regions being adjacent to first and second side surfaces of the source follower gate pattern, respectively, and a gate insulating layer between the active region and the source follower gate pattern. An upper portion of the active region includes a recess region, and the source follower gate pattern includes a body portion on the active region and a buried portion provided in the recess region and protruding below the body portion. A distance between the first and second side surfaces is a first length, and a distance between a center of the buried portion and the first side surface is a second length. The second length is greater than or equal to 0.1 times the first length and is less than 0.5 times the first length.

## Description

### BACKGROUND OF THE INVENTION

The present disclosure relates to an image sensor, and in particular, to an image sensor including a source follower transistor.

An image sensor is a device converting an optical image to electrical signals. The image sensors are classified into two types: charge-coupled device (CCD) and complementary metal-oxide-semiconductor (CMOS). The CMOS-type image sensor is called CIS for short. The CIS-type image sensor includes a plurality of pixels which are two-dimensionally arranged. Each of the unit pixel regions includes a photodiode, which is used to convert an incident light to an electric signal.

### SUMMARY

An embodiment of the inventive concept provides an image sensor with an improved RTS (random telegraph signal) noise property.

An embodiment of the inventive concept provides a method of fabricating an image sensor with an improved RTS noise property.

According to an embodiment of the inventive concept, an image sensor may include a substrate including an active region, the active region including a source region and a drain region, a source follower gate pattern on the active region, the drain region being adjacent to a first side surface of the source follower gate pattern, the source region being adjacent to a second side surface of the source follower gate pattern, and a gate insulating layer between the active region and the source follower gate pattern. An upper portion of the active region may include a recess region, and the source follower gate pattern may include a body portion on the active region and a buried portion provided in the recess region and protruding below the body portion. A distance between the first and second side surfaces may be a first length, and a distance between a center of the buried portion and the first side surface may be a second length. The second length may be greater than or equal to 0.1 times the first length and less than 0.5 times the first length.

The substrate may comprise a first surface (e.g. a lower surface) and a second surface (e.g. an upper surface), opposite to each other. An upper portion of an active region may be a portion closer to the second surface than the first surface. It will be appreciated that terms such as "upper", "lower", "above" and "below" are relative terms with respect to relative portions of the image sensor, and do not imply any orientation of the image sensor in use. The buried portion of the source follower gate pattern may protrude below the body portion, in that it may protrude (or extend) into the substrate (e.g. beyond a plane of the second surface, into the recess region).

According to an embodiment of the inventive concept, an image sensor may include a substrate including a first surface and a second surface, which are opposite to each other, an isolation pattern provided in the substrate to define a pixel region, the pixel region including an active region adjacent to the second surface, the active region including a source region and a drain region, a color filter on the first surface of the substrate, a micro lens on the color filter, a device isolation pattern provided on the second surface of the substrate to define the active region, a source follower gate pattern on the active region, and an interconnection line provided on the source follower gate pattern and electrically connected to the source follower gate pattern. The source follower gate pattern may include a body portion and a buried portion, which buried portion extends from the body portion into the substrate. The buried portion may be disposed to be closer to the drain region than to the source region.

According to an embodiment, the pixel region may further comprise a photoelectric conversion region provided in the substrate.

According to an embodiment, the drain region may be adjacent to a first side surface of the source follower gate pattern, the source region may be adjacent to a second side surface of the source follower gate pattern, a distance between the first side surface and the second side surface may be a first length, the buried portion may be formed symmetrically with respect to a center of the buried portion, a distance between a center of the buried portion and the first side surface may be a second length, and the second length may be greater than or equal to 0.1 times the first length and is less than 0.5 times the first length.

According to an embodiment, the buried portion may be provided in a recess region formed in an upper portion of the active region, a depth of the recess region may be a third length, and the second length may be smaller than the third length.

According to an embodiment of the inventive concept, an image sensor may include a circuit chip and a sensor chip, which is stacked on the circuit chip and is electrically connected to the circuit chip. The sensor chip may include a first substrate including a first surface and a second surface, which are opposite to each other, an isolation pattern defining a pixel region in the first substrate, the pixel region including an active region adjacent to the second surface, a color filter on the first surface of the substrate, a micro lens on the color filter, a source follower gate pattern on the active region, and a first interconnection layer on the second surface. The first interconnection layer may include an interconnection line electrically connected to the source follower gate pattern, and the source follower gate pattern may include a body portion, which is provided on the second surface, and a buried portion, which extends from the body portion into the first substrate. The active region may include a drain region, which is adjacent to a first side surface of the source follower gate pattern, and a source region, which is adjacent to a second side surface of the source follower gate pattern. The buried portion may be disposed to be closer to the first side surface than to the second side surface.

At least some of the above and other features of the invention are set out in the claims.

### BRIEF DESCRIPTION OF THE DRAWINGS

FIG. 1 is a circuit diagram illustrating a pixel of an image sensor according to an embodiment of the inventive concept.
FIG. 2 is a plan view illustrating an image sensor according to an embodiment of the inventive concept.
FIG. 3 is a sectional view taken along a line I-I' of FIG. 2, according to one embodiment.
FIG. 4 is a sectional view, which is taken along the line I-I' of FIG. 2 to illustrate an image sensor according to another embodiment of the inventive concept.
FIG. 5 is a sectional view, which is taken along a line II-II' of FIG. 2 to illustrate an image sensor according to an embodiment of the inventive concept.
FIG. 6 is a plan view illustrating a portion 'M' of FIG. 2 to describe pixels in an image sensor according to an embodiment of the inventive concept.
FIG. 7A is a sectional view taken along a line I-I' of FIG. 6, according to one embodiment.
FIG. 7B is a sectional view taken along a line II-II' of FIG. 6, according to one embodiment.
FIG. 8 is an enlarged sectional view illustrating a portion 'N' of FIG. 7A, according to one embodiment.
FIG. 9 is an enlarged sectional view illustrating the portion 'N' of FIG. 7A to describe a source follower transistor according to a comparative example.
FIGS. 10 to 14 are sectional views illustrating a method of fabricating an image sensor according to an embodiment of the inventive concept.
FIGS. 15 to 18 are sectional views illustrating a process of forming a portion N of FIG. 12, according to an embodiment.
FIGS. 19, 20, and 21 are plan views illustrating some of possible arrangements of color filters in an image sensor according to embodiments of the inventive concept.

### DETAILED DESCRIPTION

Example embodiments of the inventive concepts will now be described more fully with reference to the accompanying drawings, in which example embodiments are shown.

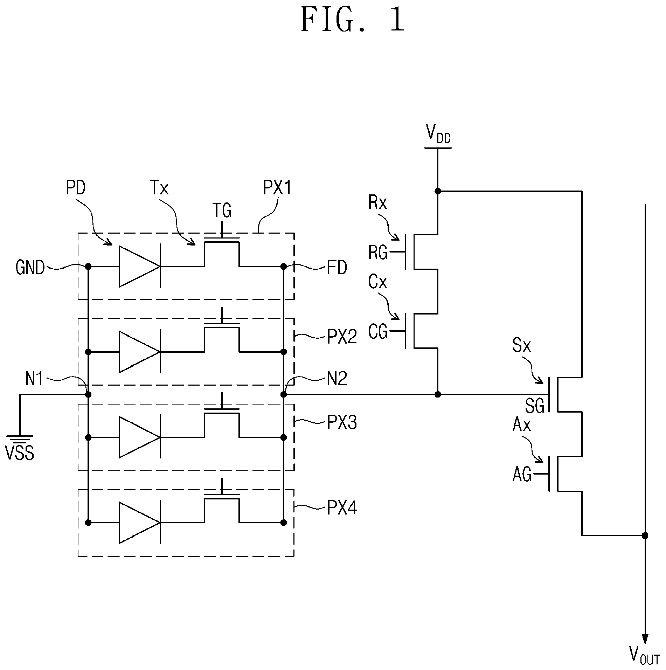

FIG. 1 is a circuit diagram illustrating a pixel of an image sensor according to an embodiment of the inventive concept.

Referring to FIG. 1, an image sensor may include first to fourth pixels PX1 to PX4. Each of the first to fourth pixels PX1 to PX4 may include a ground region GND, a photoelectric conversion region PD, a transfer transistor Tx, and a floating diffusion region FD.

The ground region GND may include a p-type impurity region. A ground voltage VSS may be applied in common to the ground regions GND of the first to fourth pixels PX1 to PX4 through a first node N1.

The photoelectric conversion region PD may be a photodiode including n- and p-type impurity regions. The floating diffusion region FD may include an n-type impurity region. The floating diffusion region FD may serve as a drain of the transfer transistor Tx.

The floating diffusion regions FD of the first to fourth pixels PX1 to PX4 may be connected in common to a second node N2. The second node N2, which is connected to the floating diffusion regions FD of the first to fourth pixels PX1 to PX4, may be connected to a source of a conversion gain transistor Cx. The conversion gain transistor Cx may be connected to a reset transistor Rx.

The second node N2 may also be electrically connected to a source follower gate SG of a source follower transistor Sx. The source follower transistor Sx may be connected to a selection transistor Ax. A source follower circuit (otherwise known as a common-drain circuit) may be a circuit including a transistor (a source follower transistor, such as source follower transistor Sx) that has a gate terminal connected to an input, a source terminal connected to an output, and a drain terminal which is common to both the input and output (e.g. the drain terminal may be connected to a voltage which acts as a reference voltage for the input and output signals).

Hereinafter, an operation of the image sensor will be described with reference to FIG. 1. In a light-blocking state, electric charges may be discharged from the floating diffusion region FD by applying a power voltage VDD to drain electrodes of the reset and source-follower transistors Rx and Sx and turning on the reset transistor Rx. Next, the reset transistor Rx may be turned off, and then, if an external light is incident from the outside, electron-hole pairs may be produced in the photoelectric conversion region PD. The holes may be moved to and accumulated in the p-type impurity region of the photoelectric conversion region PD, and the electrons may be moved to and accumulated in the n-type impurity region of the photoelectric conversion region PD. In this state, if the transfer transistor Tx is turned on, the electric charges, such as the electrons and holes, may be transferred to and accumulated in the floating diffusion region FD. A change in amount of the accumulated charges may lead to a change in gate bias of the source follower transistor Sx and consequently a change in source potential of the source follower transistor Sx. In this case, if the selection transistor Ax is turned on, an amount of the electric charges may be read out as a signal through a column line.

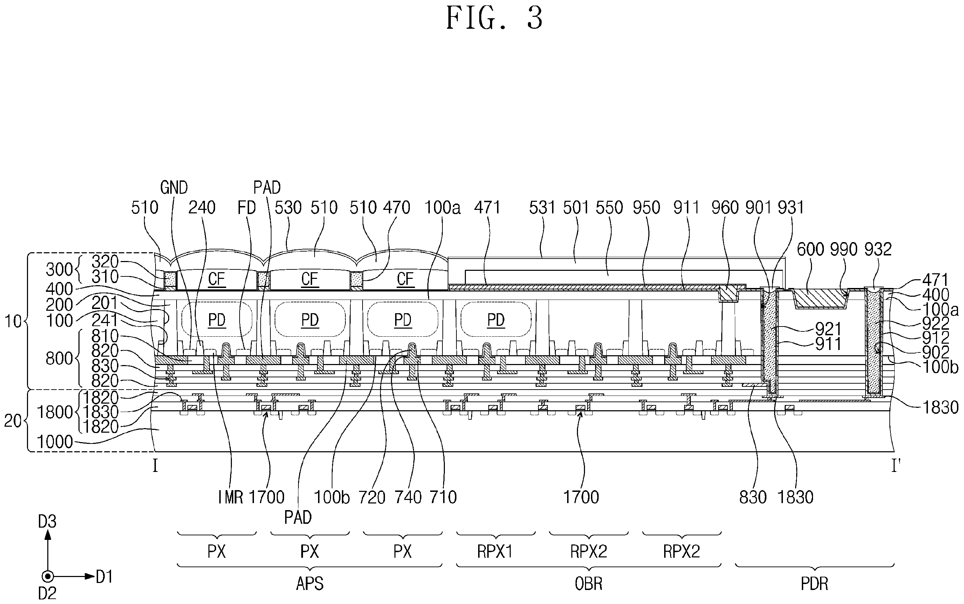

An interconnection line may be electrically connected to at least one of the transfer gate TG, the source follower gate SG, the reset gate RG, and the selection gate AG. The interconnection line may be configured to apply the power voltage VDD to the drain electrode of the reset transistor Rx or the drain electrode of the source follower transistor Sx. The interconnection line may include the column line connected to the selection transistor Ax. The interconnection line may include a first conductive structure 830, which will be described with reference to FIG. 3.

FIG. 1 illustrates the first to fourth pixels PX1 to PX4 sharing the first node N1 and the second node N2, but the inventive concept is not limited to this example.

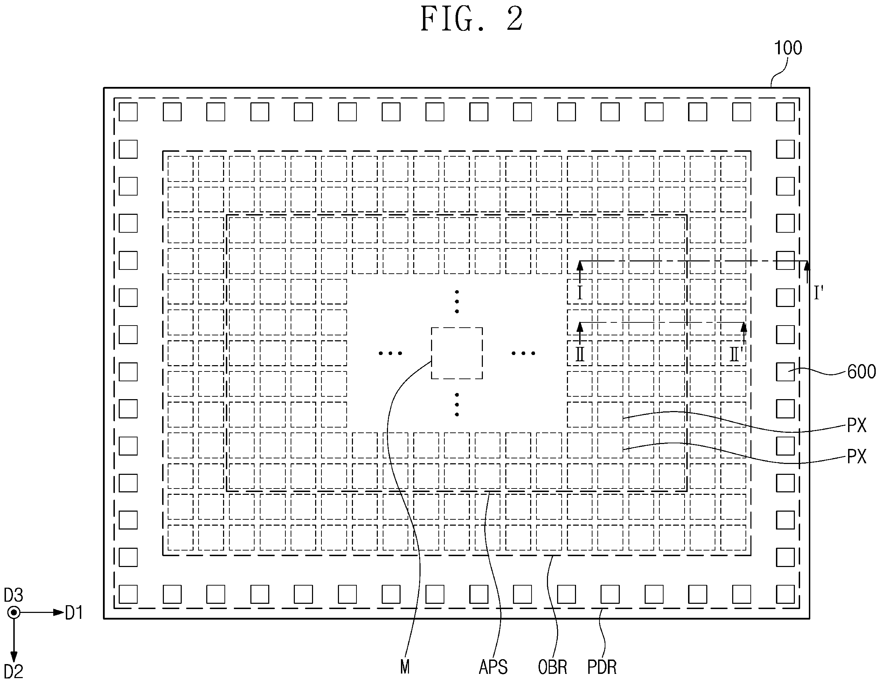

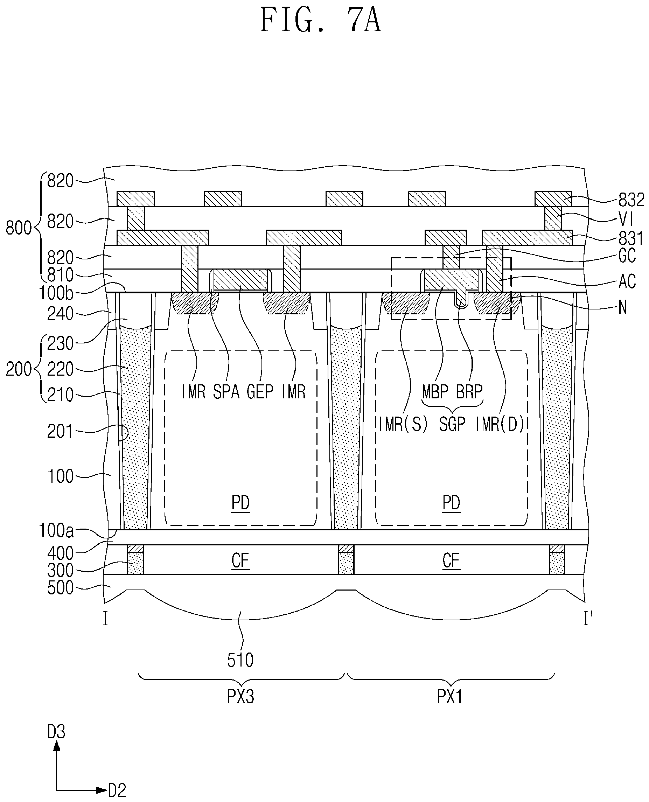

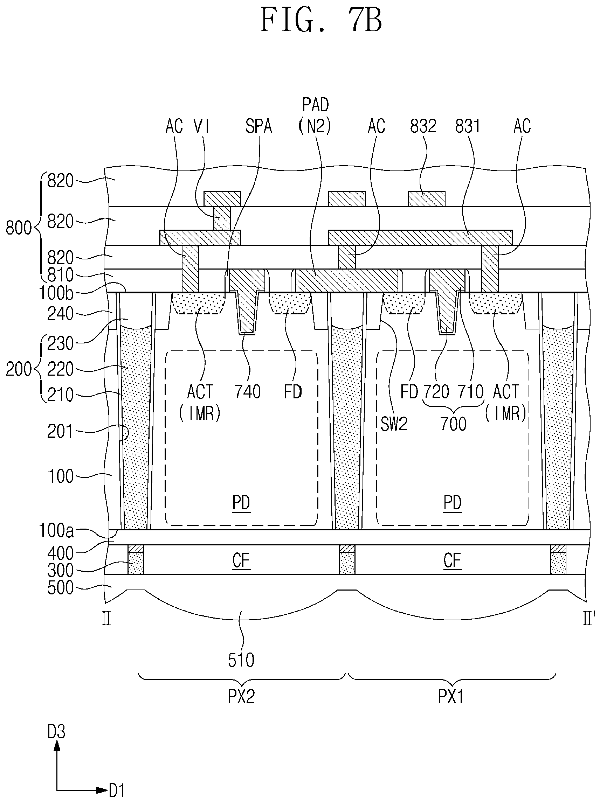

FIG. 2 is a plan view illustrating an image sensor according to an embodiment of the inventive concept. FIG. 3 is a sectional view taken along a line I-I' of FIG. 2. In addition, in certain discussions below, items labeled in FIGS. 7A and 7B are discussed in connection with FIGS. 1-3.

Referring to FIGS. 2 and 3, the image sensor may include a sensor chip 10. The sensor chip 10 may include a first substrate 100, a first interconnection layer 800, an insulating layer 400, a protection layer 470, color filters CF, a fence pattern 300, and a micro-lens layer 500 (see FIG. 7A).

When viewed in a plan view, the first substrate 100 may include a pixel array region APS, an optical black region OBR, and a pad region PDR. The pixel array region APS may be disposed in a center region of the first substrate 100. The pixel array region APS may include a plurality of pixel regions PX. The pixel described with reference to FIG. 1 may be provided in each of the pixel regions PX of the first substrate 100. For example, the elements constituting the pixel of FIG. 1 may be provided on each of the pixel regions PX. The pixel regions PX may be formed to produce photoelectric signals from incident light and to output the photoelectric signals. Ordinal numbers such as "first," "second," "third," etc. may be used simply as labels of certain elements, steps, etc., to distinguish such elements, steps, etc. from one another. Terms that are not described using "first," "second," etc., in the specification, may still be referred to as "first" or "second" in a claim. In addition, a term that is referenced with a particular ordinal number (e.g., "first" in a particular claim) may be described elsewhere with a different ordinal number (e.g., "second" in the specification or another claim).

The pixel regions PX may be two-dimensionally arranged to form a plurality of rows and a plurality of columns. The rows may be parallel to a first direction D1. The columns may be parallel to a second direction D2. In the present specification, the first direction D1 may be parallel to a first surface 100a of the first substrate 100. The second direction D2 may be parallel to the first surface 100a of the first substrate 100 but may not be parallel to the first direction D1. For example, the second direction D2 may intersect, or may be substantially perpendicular to, the first direction D1. A third direction D3 may be perpendicular to the first direction D1 and the second direction D2. For example, the third direction D3 may be substantially normal to the first surface 100a of the first substrate 100. Terms such as "same," "equal," "planar," "coplanar," "parallel," and "perpendicular," as used herein encompass identicality or near identicality including variations that may occur, for example, due to manufacturing processes. The term "substantially" may be used herein to emphasize this meaning, unless the context or other statements indicate otherwise.

The pad region PDR may be provided in an edge region of the first substrate 100 to enclose the pixel array region APS. Pads PAD may be provided on the pad region PDR. The pads PAD may be used to output electrical signals, which are produced in the pixel regions PX, to the outside. Alternatively, the pads PAD may be used to deliver an external electrical signal or voltage to the pixel regions PX. Since the pad region PDR is disposed in the edge region of the first substrate 100, the pads PAD may be easily coupled to the outside. The optical black region OBR will be described below. Hereinafter, the pixel array region APS of the sensor chip 10 of the image sensor will be described in more detail.

The first substrate 100 may have the first surface 100a and a second surface 100b that are opposite to each other. The first surface 100a of the first substrate 100 may be a front surface, and the second surface 100b may be a rear surface. Light may be incident into the first substrate 100 through the first surface 100a. The first substrate 100 may be a semiconductor substrate or a silicon-on-insulator (SOI) substrate including of a crystalline semiconductor material. The semiconductor substrate may include, for example, a silicon substrate, a germanium substrate, or a silicon-germanium substrate. The first substrate 100 may further include group 3 elements. The group 3 element may be an impurity of a first conductivity type. For example, the first substrate 100 may have the first conductivity type (e.g., a p-type). As an example, the impurity of the first conductivity type may include aluminum (Al), boron (B), indium (In), and/or gallium (Ga).

The first substrate 100 may include a plurality of photoelectric conversion regions PD provided therein. The photoelectric conversion regions PD may be located between the first surface 100a and the second surface 100b of the first substrate 100. The photoelectric conversion regions PD may be respectively provided in the pixel regions PX of the first substrate 100. The photoelectric conversion region PD of FIG. 3 may be the same as the photoelectric conversion region PD of FIG. 1.

The photoelectric conversion region PD may further include group 5 elements. The group 5 element may be an impurity of a second conductivity type. For example, the photoelectric conversion region PD may be an impurity region of the second conductivity type. The second conductivity type may be an n-type that is different from the first conductivity type. The impurity of the second conductivity type may be or include phosphorus, arsenic, bismuth, and/or antimony. The photoelectric conversion region PD may be adjacent to the first surface 100a of the first substrate 100. The photoelectric conversion region PD may extend from the first surface 100a toward the second surface 100b.

An isolation pattern 200 may be provided in the first substrate 100 to define the pixel regions PX. For example, the isolation pattern 200 may be provided between adjacent ones of the pixel regions PX. The isolation pattern 200 may be a pixel isolation pattern. The isolation pattern 200 may be provided in a first trench 201. The first trench 201 may be recessed from the second surface 100b of the first substrate 100 toward the first surface 100a.

The isolation pattern 200 may be a deep trench isolation layer. In the present embodiment, the isolation pattern 200 may penetrate the first substrate 100. In an embodiment, the isolation pattern 200 may not penetrate the first substrate 100 and may be spaced apart from the first surface 100a of the first substrate 100. A width of the isolation pattern 200 adjacent to the second surface 100b may be larger than a width of the isolation pattern 200 adjacent to the first surface 100a.

The color filters CF may be disposed on the first surface 100a of the first substrate 100 and on the pixel regions PX, respectively. For example, the color filters CF may be respectively provided at positions corresponding to the photoelectric conversion regions PD. In an embodiment, each of the color filters CF may be one of red, blue, and green filters. The color filters CF may be arranged to form color filter arrays. For example, the color filters CF may be two-dimensionally arranged in a Bayer pattern.

In an embodiment, the color filters CF may further include a white filter. For example, the color filters CF may include red, blue, green, and white filters, which are two-dimensionally arranged.

The fence pattern 300 may be disposed on the isolation pattern 200. For example, the fence pattern 300 may vertically overlap the isolation pattern 200 (e.g., may overlap the isolation pattern 200 in the vertical direction D3). The fence pattern 300 may be interposed between adjacent pairs of the color filters CF to separate the color filters CF from each other. For example, the color filters CF may be physically and optically separated from each other by the fence pattern 300.

The fence pattern 300 may have a planar shape corresponding to the isolation pattern 200. For example, the fence pattern 300 may have a grid shape. When viewed in a plan view, the fence pattern 300 may be provided to surround each of the pixel regions PX. The fence pattern 300 may surround each of the color filters CF. The fence pattern 300 may include first portions and second portions. The first portions may extend parallel to the first direction D1 and may be spaced apart from each other in the second direction D2. The second portions may extend parallel to the second direction D2 and may be spaced apart from each other in the first direction D1. The second portions may cross the first portions.

The fence pattern 300 may include a first fence pattern 310 and a second fence pattern 320. The first fence pattern 310 may be disposed between the insulating layer 400 and the second fence pattern 320. The first fence pattern 310 may be formed of or include at least one conductive material (e.g., at least one metal and/or metal nitride). For example, the first fence pattern 310 may be formed of or include titanium and/or titanium nitride.

The second fence pattern 320 may be disposed on the first fence pattern 310. The second fence pattern 320 may be formed of or include a material different from the first fence pattern 310. The second fence pattern 320 may be formed of or include an organic material. The second fence pattern 320 may include a low-refractive material and may have an insulating property. A low-refractive material may be a material that has a low refractive index (e.g. relative to the refractive index of silicon dioxide). For instance, a low-refractive material may have a refractive index that is less than that of silicon dioxide.

The insulating layer 400 may be interposed between the first substrate 100 and the color filters CF and between the isolation pattern 200 and the fence pattern 300. The insulating layer 400 may cover the first surface 100a of the first substrate 100 and a top surface of the isolation pattern 200. The insulating layer 400 may be a back-side insulating layer. The insulating layer 400 may include a bottom antireflective coating (hereinafter, BARC) layer. The insulating layer 400 may include a plurality of layers which are configured to have different functions from each other.

In an embodiment, the insulating layer 400 may include a first insulating layer, a second insulating layer, a third insulating layer, a fourth insulating layer, and a fifth insulating layer, which are sequentially stacked on the first surface 100a of the first substrate 100. The first insulating layer may cover the first surface 100a of the first substrate 100. The first and second insulating layers may be fixed-charge layers. Each of the fixed-charge layers may be formed of a metal oxide layer or a metal fluoride layer. In an embodiment, the metal oxide layer may have an oxygen content that is lower than that of its stoichiometric ratio, and the metal fluoride layer may have a fluorine content that is lower than that of its stoichiometric ratio.

For example, the first insulating layer may be formed of metal oxide or metal fluoride containing at least one metallic element selected from the group consisting of hafnium (Hf), zirconium (Zr), aluminum (Al), tantalum (Ta), titanium (Ti), yttrium (Y), and lanthanide. The second insulating layer may be formed of or include at least one of the metal oxides or metal fluorides, which have been listed for the first insulating layer. However, the material for the second insulating layer may be different from that for the first insulating layer. As an example, the first insulating layer may be formed of or include aluminum oxide, and the second insulating layer may be formed of or include hafnium oxide.

Each of the first and second insulating layers may have a negative fixed charge and may be configured to lead to hole accumulation. Due to the first and second insulating layers, it may be possible to effectively suppress dark current and white spot issues, which may occur in the first substrate 100. A thickness of the second insulating layer may be larger than a thickness of the first insulating layer.

The third insulating layer may be disposed on the second insulating layer. The third insulating layer may be formed of or include a first silicon-containing material. The first silicon-containing material may include, for example, tetraethyl orthosilicate (TEOS) or silicon oxide. The third insulating layer may have a good gap-filling property. The third insulating layer may be formed by, for example, a plasma-enhanced chemical vapor deposition (PE-CVD) process, but the inventive concept is not limited to this example. A thickness of the third insulating layer may be larger than the thickness of the first insulating layer and may be larger than the thickness of the second insulating layer.

The fourth insulating layer may be disposed on the third insulating layer. The fourth insulating layer may be formed of or include a material different from the third insulating layer. The fourth insulating layer may include a second silicon-containing material, which is different from the first silicon-containing material. As an example, the fourth insulating layer may be formed of or include silicon nitride. A thickness of the fourth insulating layer may be larger than the thickness of the third insulating layer.

The fifth insulating layer may be disposed between the fourth insulating layer and the first fence pattern 310 and between the fourth insulating layer and the color filters CF. The fifth insulating layer may be in physical contact with a bottom surface of the first fence pattern 310. The fifth insulating layer may be an adhesive layer or a capping layer. The fifth insulating layer may be formed of or include at least one of a high-k dielectric material or a metal oxide material. A high-k dielectric material may be a material having a high dielectric constant relative to silicon dioxide (e.g. a higher dielectric constant than silicon dioxide). The fifth insulating layer may be formed of or include the same material as the second insulating layer. For example, the fifth insulating layer may be formed of or include hafnium oxide. A thickness of the fifth insulating layer may be larger than the thickness of the first insulating layer and the thickness of the second insulating layer and may be smaller than the thickness of the third insulating layer and the thickness of the fourth insulating layer.

The number of the layers constituting the insulating layer 400 may be variously changed, unlike the embodiments described above. For example, at least one of the first to fifth insulating layers may be omitted.

The protection layer 470 may cover the insulating layer 400 and the fence pattern 300. The protection layer 470 may be formed of or include at least one high-k dielectric material and may have an insulating property. For example, the protection layer 470 may be formed of or include aluminum oxide or hafnium oxide. In an embodiment, the protection layer 470 may be formed of or include aluminum oxide, but the inventive concept is not limited to this example. The protection layer 470 may protect the photoelectric conversion regions PD of the first substrate 100 from harmful external environment (e.g., moisture).

The color filters CF may be provided on the protection layer 470. The color filters CF may be spaced apart from each other by the fence pattern 300. The uppermost surface of each color filter CF may be coplanar with the top surface of the fence pattern 300. In an embodiment, the uppermost surface of each color filter CF may be higher than the top surface of the fence pattern 300.

The micro-lens layer 500 may be provided on the first surface 100a of the first substrate 100. For example, the micro-lens layer 500 may be provided on the color filters CF. The protection layer 470 may be interposed between the second fence pattern 320 and the micro-lens layer 500.

The micro-lens layer 500 may include a plurality of micro lenses 510 having a convex shape. The micro lenses 510 may be provided at respective positions corresponding to the photoelectric conversion regions PD of the first substrate 100. For example, the micro lenses 510 may be provided on the color filters CF, respectively, and may correspond to the color filters CF, respectively. The micro lenses 510 may be arranged in the first and second directions D1 and D2 to form an array when viewed in a plan view. Each of the micro lenses 510 may protrude in a direction away from the first surface 100a of the first substrate 100. Each of the micro lenses 510 may have a hemispherical section. The micro lenses 510 may be used to focus incident light on the photoelectric conversion regions PD.

The micro-lens layer 500 may be transparent to light. The micro-lens layer 500 may be formed of or include at least one organic material (e.g., polymers). For example, the micro-lens layer 500 may be formed of or include at least one of photoresist materials or thermosetting resins.

A lens coating layer 530 may be provided on the micro-lens layer 500. The lens coating layer 530 may be transparent. The lens coating layer 530 may conformally cover a top surface of the micro-lens layer 500. The lens coating layer 530 may protect the micro-lens layer 500.

The first substrate 100 may include the ground region GND, the floating diffusion region FD, and an impurity region IMR, which are provided near the second surface 100b thereof. The ground region GND, the floating diffusion region FD, and the impurity region IMR may be disposed in each of the pixel regions PX. The ground region GND, the floating diffusion region FD, and the impurity region IMR may have bottom surfaces that are vertically spaced apart from the photoelectric conversion region PD.

The ground region GND may be highly doped with impurities to have a first conductivity type (e.g., p+ type). The floating diffusion region FD and the impurity region IMR may be doped with impurities to form a second conductivity type (e.g., n-type).

The impurity region IMR may be an active region for an operation of a transistor. The impurity region IMR may include source/drain regions of at least one of the conversion gain transistor Cx, the reset transistor Rx, the source follower transistor Sx, and the selection transistor Ax described with reference to FIG. 1.

A device isolation pattern 240 may be provided to be adjacent to the second surface 100b of the first substrate 100. The device isolation pattern 240 may define an active region in the pixel region PX. In detail, the device isolation pattern 240 may define the ground region GND, the floating diffusion region FD, and the impurity region IMR, in the pixel region PX.

The device isolation pattern 240 may be provided in a second trench 241, and the second trench 241 may be recessed from the second surface 100b of the first substrate 100. The device isolation pattern 240 may be a shallow device isolation (STI) layer. A depth of the device isolation pattern 240 may be smaller than a depth of the isolation pattern 200. A portion of the device isolation pattern 240 may be connected to a side surface of a first isolation pattern 210, which will be described with reference to FIGS. 7A and 7B. The device isolation pattern 240 may be formed of or include at least one of, for example, silicon oxide, silicon nitride, and/or silicon oxynitride.

A gapfill gate pattern 700 (see FIG. 7B) may be provided on the second surface 100b of the first substrate 100. The gapfill gate pattern 700 may include the transfer gate TG of the transfer transistor Tx previously described with reference to FIG. 1. Although not shown in FIG. 3, at least one additional gate pattern may be provided on each of the pixel regions PX.

The additional gate pattern may serve as a gate electrode of at least one of the conversion gain transistor Cx, the source follower transistor Sx, the reset transistor Rx, and the selection transistor Ax previously described with reference to FIG. 1. For example, the additional gate pattern may include a conversion gain gate CG, the source follower gate SG, the reset gate RG, or the selection gate AG.

The gapfill gate pattern 700 may have a buried-type gate structure. For example, the gapfill gate pattern 700 may include a first portion 710 and a second portion 720. The first portion 710 of the gapfill gate pattern 700 may be disposed on the second surface 100b of the first substrate 100. The second portion 720 of the gapfill gate pattern 700 may be buried in the first substrate 100. The second portion 720 of the gapfill gate pattern 700 may be connected to the first portion 710. The gapfill gate pattern 700 may have a planar gate structure, unlike the illustrated structure. In this case, the gapfill gate pattern 700 may not include the second portion 720. The gapfill gate pattern 700 may be formed of or include at least one of metallic materials, metal silicide materials, polysilicon, or combinations thereof. Here, the polysilicon may include or may be doped polysilicon.

A gate insulating pattern 740 may be interposed between the gapfill gate pattern 700 and the first substrate 100. The gate insulating pattern 740 may be formed of or include at least one of, for example, silicon-based insulating materials (e.g., silicon oxide, silicon nitride, and/or silicon oxynitride) and/or high-k dielectric materials (e.g., hafnium oxide and/or aluminum oxide).

A pad PAD may be provided on the ground region GND. The pad PAD may be provided on the ground regions GND of the pixel regions PX, which are adjacent to each other, to electrically connect them to each other. The pad PAD on the ground regions GND may include or be the first node N1 of FIG. 1.

The pad PAD may also be provided on the floating diffusion region FD. The pad PAD may be provided on the floating diffusion regions FD of the pixel regions PX, which are adjacent to each other, to electrically connect them to each other. The pad PAD on the floating diffusion regions FD may include the second node N2 of FIG. 1.

The pad PAD may be formed of or include at least one of metallic materials, metal silicide materials, polysilicon, or combinations thereof. For example, the pad PAD may be formed of or include doped polysilicon.

The first interconnection layer 800 may be disposed on the second surface 100b of the first substrate 100. The first interconnection layer 800 may include a first interlayer insulating layer 810, second interlayer insulating layers 820, and a first conductive structure 830. The first interlayer insulating layer 810 may cover the second surface 100b of the first substrate 100 and the gapfill gate pattern 700. The second interlayer insulating layers 820 may be stacked on the first interlayer insulating layer 810. The first and second interlayer insulating layers 810 and 820 may be formed of or include at least one silicon-based insulating material (e.g., silicon oxide, silicon nitride, and/or silicon oxynitride).

The first conductive structure 830 may be provided in the interlayer insulating layers 810 and 820. The first conductive structure 830 may include contacts, interconnection lines, and vias. The contact may be provided in the first interlayer insulating layer 810 and may be connected to at least one of the gapfill gate pattern 700, the pad PAD, and the impurity regions IMR. The interconnection line of the first conductive structure 830 may be connected to the contact. The via of the first conductive structure 830 may be provided to penetrate at least one of the second interlayer insulating layers 820 and to connect vertically-adjacent ones of the interconnection lines to each other. The first conductive structure 830 may be used to deliver photoelectric signals, which are output from the photoelectric conversion regions PD.

Hereinafter, the circuit chip 20 of the image sensor and the optical black region OBR and the pad region PDR of the first substrate 100 will be described in more detail. Referring back to FIGS. 2 and 3, the optical black region OBR of the first substrate 100 may be interposed between the pixel array region APS and the pad region PDR. The optical black region OBR may include a first reference pixel region RPX1 and a second reference pixel region RPX2. The first reference pixel region RPX1 may be disposed between the second reference pixel region RPX2 and the pixel array region APS. In the optical black region OBR, the photoelectric conversion region PD may be provided in the first reference pixel region RPX1. The photoelectric conversion region PD of the first reference pixel region RPX1 may have the same planar area and volume as the photoelectric conversion regions PD of the pixel regions PX. The photoelectric conversion region PD may not be provided in the second reference pixel region RPX2. The impurity regions IMR, the gapfill gate pattern 700, and the device isolation pattern 240 may be disposed in each of the first and second reference pixel regions RPX1 and RPX2.

The insulating layer 400 may extend from the pixel array region APS to the pad region PDR through the optical black region OBR. A light-blocking layer 950 may be provided on the optical black region OBR. The light-blocking layer 950 may be disposed on a top surface of the insulating layer 400. Due to the light-blocking layer 950, light may be prevented from being incident into the photoelectric conversion region PD of the optical black region OBR. The pixels in the first and second reference pixel regions RPX1 and RPX2 of the optical black region OBR may be configured to output noise signals, not photoelectric signals. The noise signal may be produced by electrons, which are generated by heat or a dark current. The light-blocking layer 950 may not veil the pixel array region APS, and thus, light may be incident into the photoelectric conversion regions PD in the pixel array region APS. It may be possible to remove the noise signal from photoelectric signals, which are output from the pixel regions PX. The light-blocking layer 950 may be formed of or include at least one metallic material (e.g., tungsten, copper, aluminum, or alloys thereof).

In the optical black region OBR of the first substrate 100, a first conductive pattern 911 may be disposed between the insulating layer 400 and the light-blocking layer 950. The first conductive pattern 911 may serve as a barrier layer or an adhesive layer. The first conductive pattern 911 may be formed of or include at least one metallic material and/or metal nitride. For example, the first conductive pattern 911 may be formed of or include at least one metallic material (e.g., copper, tungsten, aluminum, titanium, tantalum, or alloys thereof). The first conductive pattern 911 may not extend to a region on the pixel array region APS of the first substrate 100.

In the optical black region OBR of the first substrate 100, a contact plug 960 may be provided on the first surface 100a of the first substrate 100. The contact plug 960 may be disposed on the outermost one of the isolation patterns 200 in the optical black region OBR. A contact trench penetrating the insulating layer 400 may be defined on the first surface 100a of the first substrate 100, and the contact plug 960 may be provided in the contact trench.

The contact plug 960 may be formed of or include a material that is different from the light-blocking layer 950. For example, the contact plug 960 may be formed of or include at least one metallic material (e.g., aluminum). The first conductive pattern 911 may extend into regions between the contact plug 960 and the insulating layer 400 and between the contact plug 960 and the isolation pattern 200.

A protection insulating layer 471 may be provided on the optical black region OBR. The protection insulating layer 471 may be disposed on a top surface of the light-blocking layer 950 and a top surface of the contact plug 960. The protection insulating layer 471 may include the same material as the protection layer 470 and may be connected to the protection layer 470. The protection insulating layer 471 and the protection layer 470 may be provided as a single object. Alternatively, the protection insulating layer 471 may be formed by a process, which is distinct from that for the protection layer 470, and may be spaced apart from the protection layer 470. The protection insulating layer 471 may be formed of or include at least one high-k dielectric material (e.g., aluminum oxide and/or hafnium oxide).

A filtering layer 550 may be further disposed on the first surface 100a of the optical black region OBR. The filtering layer 550 may cover a top surface of the protection insulating layer 471. The filtering layer 550 may block light which is not filtered by the color filters CF. For example, the filtering layer 550 may be configured to block infrared light. The filtering layer 550 may include a blue color filter but the inventive concept is not limited to this example.

An organic layer 501 may be provided on a top surface of the filtering layer 550. The organic layer 501 may be transparent. A top surface of the organic layer 501 may be substantially flat. The organic layer 501 may be formed of or include, for example, at least one polymer. The organic layer 501 may have an insulating property. In an embodiment, unlike that illustrated in the drawings, the organic layer 501 may be connected to the micro lens layer 500. The organic layer 501 may be formed of or include the same material as the micro lens layer 500.

A coating layer 531 may be provided on the organic layer 501. The coating layer 531 may conformally cover the top surface of the organic layer 501. The coating layer 531 may include an insulating material and may be transparent. The coating layer 531 may be formed of or include the same material as the lens coating layer 530.

The image sensor may further include the circuit chip 20. The circuit chip 20 may be stacked on the sensor chip 10. The circuit chip 20 may include a second interconnection layer 1800 and a second substrate 1000. The second interconnection layer 1800 may be interposed between the first interconnection layer 800 and the second substrate 1000. Integrated circuits 1700 may be disposed on a top surface of the second substrate 1000 or in the second substrate 1000. The integrated circuits 1700 may include logic circuits, memory circuits, or combinations thereof. The integrated circuits 1700 may include, for example, transistors.

The second interconnection layer 1800 may include third interlayer insulating layers 1820 and a second conductive structure 1830. The second conductive structures 1830 may be provided between the third interlayer insulating layers 1820 or in the third interlayer insulating layers 1820. The second conductive structures 1830 may be electrically connected to the integrated circuits 1700. The second conductive structures 1830 may further include a via pattern, and in an embodiment, the via pattern may be coupled to other elements of the second conductive structures 1830 in the third interlayer insulating layers 1820.

The outer coupling pad 600 may be provided on the pad region PDR of the first substrate 100. The outer coupling pad 600 may be adjacent to the first surface 100a of the first substrate 100. The outer coupling pad 600 may be buried in the first substrate 100. For example, a pad trench 990 may be defined on the first surface 100a of the pad region PDR of the first substrate 100, and the outer coupling pad 600 may be provided in the pad trench 990. The outer coupling pad 600 may be formed of or include at least one metallic material (e.g., aluminum, copper, tungsten, titanium, tantalum, or alloys thereof). In a process of mounting the image sensor, a bonding wire may be formed on the outer coupling pad 600 and may be coupled to the outer coupling pad 600. The outer coupling pad 600 may be electrically connected to an external device through the bonding wire.

A first penetration hole 901 may be defined at a region adjacent to a first side of the outer coupling pad 600. The first penetration hole 901 may be provided between the outer coupling pad 600 and the contact plug 960. The first penetration hole 901 may penetrate the insulating layer 400, the first substrate 100, and the first interconnection layer 800. In an embodiment, the first penetration hole 901 may further penetrate at least a portion of the second interconnection layer 1800. The first penetration hole 901 may have a first bottom surface and a second bottom surface. The first bottom surface of the first penetration hole 901 may be formed to expose the first conductive structure 830. The second bottom surface of the first penetration hole 901 may be disposed at a level lower than the first bottom surface. The second bottom surface of the first penetration hole 901 may be formed to expose the second conductive structure 1830.

The first conductive pattern 911 may extend from the optical black region OBR to a region on the pad region PDR. The first conductive pattern 911 may cover an inner side surface of the first penetration hole 901. The first conductive pattern 911 in the first penetration hole 901 may contact a top surface of the first conductive structure 830. Accordingly, the first conductive structure 830 may be electrically connected to the second isolation pattern 220, which will be described with reference to FIG. 7, through the first conductive pattern 911. It will be understood that when an element is referred to as being "connected" or "coupled" to or "on" another element, it can be directly connected or coupled to or on the other element or intervening elements may be present. In contrast, when an element is referred to as being "directly connected" or "directly coupled" to another element, or as "contacting" or "in contact with" another element (or using any form of the word "contact"), there are no intervening elements present at the point of contact.

The first conductive pattern 911 in the first penetration hole 901 may also be coupled to a top surface of the second conductive structure 1830. The second conductive structure 1830 may be electrically connected to the first conductive structure 830 and the second isolation pattern 220 through the first conductive pattern 911.

A first gapfill pattern 921 may be provided in the first penetration hole 901 to fill the first penetration hole 901. The first gapfill pattern 921 may be formed of or include at least one low refractive material and may have an insulating property. The first gapfill pattern 921 may be formed of or include the same material as the first fence pattern 310. A top surface of the first gapfill pattern 921 may have a recessed portion. For example, a center portion of the top surface of the first gapfill pattern 921 may be lower than its edge portion.

A first capping pattern 931 may be disposed on the top surface of the first gapfill pattern 921 to fill the recessed portion. The first capping pattern 931 may have a substantially flat top surface. The first capping pattern 931 may be formed of or include at least one insulating polymer (e.g., photoresist materials).

A second penetration hole 902 may be defined at a region adjacent to a second side of the outer coupling pad 600. The second penetration hole 902 may be provided to penetrate the insulating layer 400, the first substrate 100, and the first interconnection layer 800. In an embodiment, the second penetration hole 902 may penetrate a portion of the second interconnection layer 1800 and may expose the second conductive structure 1830.

A second conductive pattern 912 may be provided on the pad region PDR. The second conductive pattern 912 may be provided in the second penetration hole 902 to conformally cover side and bottom surfaces of the second penetration hole 902. The second conductive pattern 912 may be electrically connected to the second conductive structure 1830.

The second conductive pattern 912 may be interposed between the outer coupling pad 600 and the pad trench 990 to cover bottom and side surfaces of the outer coupling pad 600. During the operation of the image sensor, the integrated circuits 1700 of the circuit chip 20 may transmit and receive electrical signals through the second conductive structure 1830, the second conductive pattern 912, and the outer coupling pad 600.

A second gapfill pattern 922 may be provided in the second penetration hole 902 to fill the second penetration hole 902. The second gapfill pattern 922 may be formed of or include at least one low refractive material and may have an insulating property. For example, the second gapfill pattern 922 may be formed of or include the same material as the first fence pattern 310. A top surface of the second gapfill pattern 922 may have a recessed portion.

A second capping pattern 932 may be disposed on the top surface of the second gapfill pattern 922 to fill the recessed portion. The second capping pattern 932 may have a substantially flat top surface. The second capping pattern 932 may be formed of or include at least one insulating polymer (e.g., photoresist materials).

The protection insulating layer 471 may extend from the optical black region OBR to a region on the pad region PDR. The protection insulating layer 471 may be provided on the top surface of the insulating layer 400 and may extend into the first penetration hole 901 and the second penetration hole 902. In the first penetration hole 901, the protection insulating layer 471 may be interposed between the first conductive pattern 911 and the first gapfill pattern 921. In the second penetration hole 902, the protection insulating layer 471 may be interposed between the second conductive pattern 912 and the second gapfill pattern 922. The protection insulating layer 471 may be provided to expose the outer coupling pad 600.

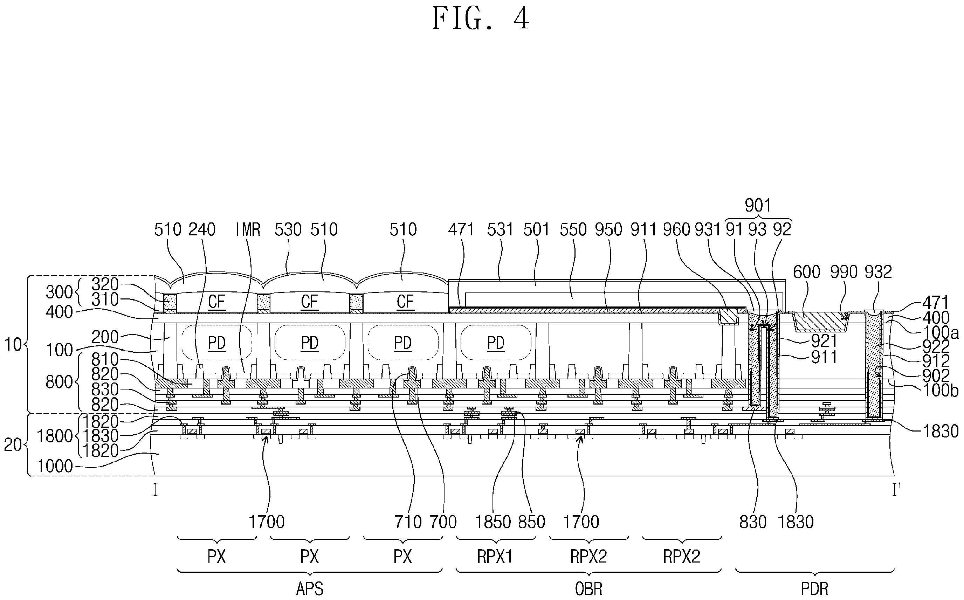

FIG. 4 is a sectional view, which is taken along the line I-I' of FIG. 2 to illustrate an image sensor according to an embodiment of the inventive concept. For concise description, elements previously described with reference to FIGS. 1 to 3, and which may have the same structure and/or perform the same function as in FIGS. 1 to 3, may be identified by the same reference number without repeating an overlapping description thereof.

Referring to FIGS. 2 and 4, the image sensor may include the sensor chip 10 and the circuit chip 20. The sensor chip 10 may include a first connection pad 850. The first connection pad 850 may be exposed on a bottom surface of the sensor chip 10. The first connection pad 850 may be disposed in the lowermost one of the second interlayer insulating layers 820. The first connection pad 850 may be electrically connected to the first conductive structure 830. The first connection pad 850 may be formed of or include at least one conductive material (e.g., metals). For example, the first connection pad 850 may be formed of or include copper. Alternatively, the first connection pad 850 may be formed of or include at least one of aluminum, tungsten, titanium, and/or alloys thereof.

The circuit chip 20 may include a second connection pad 1850. The second connection pad 1850 may be exposed on a top surface of the circuit chip 20. The second connection pad 1850 may be disposed in the uppermost one of the third interlayer insulating layers 1820. The second connection pad 1850 may be electrically connected to the integrated circuits 1700. The second connection pad 1850 may be formed of or include at least one conductive material (e.g., metals). For example, the second connection pad 1850 may be formed of or include copper. Alternatively, the second connection pad 1850 may be formed of or include at least one of aluminum, tungsten, titanium, and/or alloys thereof.

The circuit chip 20 may be connected to the sensor chip 10 in a direct bonding manner. For example, the first connection pad 850 and the second connection pad 1850 may be vertically aligned with each other and may be in contact with each other. Accordingly, the second connection pad 1850 may be directly bonded to the first connection pad 850. As a result, the integrated circuits 1700 of the circuit chip 20 may be electrically connected to the transistors or the outer coupling pad 600 of the sensor chip 10 through the first and second connection pads 850 and 1850.

The second interlayer insulating layer 820 may be directly adhered to the third interlayer insulating layer 1820. In this case, a chemical bond may be formed between the second interlayer insulating layer 820 and the third interlayer insulating layer 1820.

The first penetration hole 901 may include a first penetration hole portion 91, a second penetration hole portion 92, and a third penetration hole portion 93. The first penetration hole portion 91 may penetrate the insulating layer 400, the first substrate 100, and the first interconnection layer 800 and may have a first bottom surface. The second penetration hole portion 92 may penetrate the insulating layer 400, the first substrate 100, and the first interconnection layer 800 and may be extended into an upper portion of the second interconnection layer 1800. The second penetration hole portion 92 may have a second bottom surface, which is formed to expose a top surface of the second conductive structure 1830. A side surface of the second penetration hole portion 92 may be spaced apart from a side surface of the first penetration hole portion 91. The third penetration hole portion 93 may be provided between an upper portion of the first penetration hole portion 91 and an upper portion of the second penetration hole portion 92 and may be connected to the upper portion of the first penetration hole portion 91 and the upper portion of the second penetration hole portion 92. The first conductive pattern 911, the protection insulating layer 471, and the first gapfill pattern 921 may be provided in the first penetration hole 901. The first conductive pattern 911 may cover inner surfaces of the first penetration hole portion 91, the second penetration hole portion 92, and the third penetration hole portion 93.

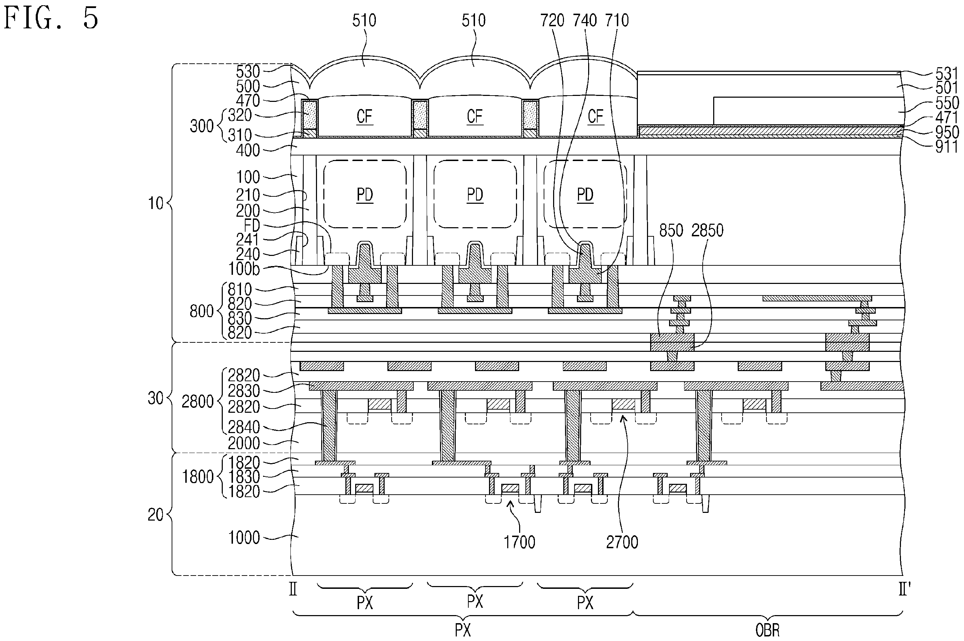

FIG. 5 is a sectional view, which is taken along a line II-II' of FIG. 2 to illustrate an image sensor according to another embodiment of the inventive concept. For concise description, elements previously described with reference to FIGS. 1 to 4 and which may have the same structure and/or perform the same function as in FIGS. 1 to 4 may be identified by the same reference number without repeating an overlapping description thereof.

Referring to FIGS. 2 and 5, the image sensor may further include an intermediate chip 30 interposed between the sensor chip 10 and the circuit chip 20. The intermediate chip 30 may include a third interconnection layer 2800 and a third substrate 2000. The third interconnection layer 2800 may be interposed between the first interconnection layer 800 and the third substrate 2000. The second interconnection layer 1800 of the circuit chip 20 may be provided below the third substrate 2000.

Driving transistors 2700 may be provided on a top surface of the third substrate 2000. The driving transistors 2700 may include the conversion gain transistor Cx, the reset transistor Rx, the source follower transistor Sx, and the selection transistor Ax described with reference to FIG. 1. For example, according to the present embodiment, the photoelectric conversion region PD, the transfer transistor Tx, and the floating diffusion region FD of FIG. 1 may be provided in or on the first substrate 100 of the sensor chip 10. The conversion gain transistor Cx, the reset transistor Rx, the source follower transistor Sx, and the selection transistor Ax of FIG. 1 may be provided on a third substrate 3000 of the intermediate chip 30.

The third interconnection layer 2800 may include fourth interlayer insulating layers 2820 and a third conductive structure 2830. The third conductive structures 2830 may be provided between or in the fourth interlayer insulating layers 2820. The third conductive structures 2830 may be electrically connected to the driving transistors 2700. The third conductive structures 2830 may include contacts, interconnection lines, and vias.

The sensor chip 10 may include the first connection pad 850. The first connection pad 850 may be exposed to the outside of the sensor chip 10 near a bottom surface of the sensor chip 10. The first connection pad 850 may be disposed in the lowermost one of the second interlayer insulating layers 820. The first connection pad 850 may be electrically connected to the first conductive structure 830.

The intermediate chip 30 may include a third connection pad 2850. The third connection pad 2850 may be exposed to the outside of the intermediate chip 30 near a top surface of the intermediate chip 30. The third connection pad 2850 may be disposed in the uppermost one of the fourth interlayer insulating layers 2820. The third connection pad 2850 may be electrically connected to the driving transistors 2700. The third connection pad 2850 may be formed of or include at least one conductive material (e.g., metallic materials). For example, the third connection pad 2850 may be formed of or include copper. As another example, the third connection pad 2850 may be formed of or include at least one of aluminum, tungsten, titanium, and/or alloys thereof.

The intermediate chip 30 may be connected to the sensor chip 10 by a direct bonding method. For example, the first connection pad 850 and the third connection pad 2850 may be vertically aligned with each other, and the first connection pad 850 and the third connection pad 2850 may be in contact with each other. Thus, the third connection pad 2850 may be directly bonded to the first connection pad 850. As a result, the driving transistors 2700 of the intermediate chip 30 may be electrically connected to the floating diffusion regions FD of the sensor chip 10 through the first and third connection pads 850 and 2850.

The second interlayer insulating layer 820 may be directly attached to the fourth interlayer insulating layer 2820. In this case, a chemical bond may be formed between the second interlayer insulating layer 820 and the fourth interlayer insulating layer 2820.

The intermediate chip 30 may further include penetration vias 2840 penetrating the third substrate 2000. Each of the penetration vias 2840 may electrically connect the third interconnection layer 2800 to the second interconnection layer 1800. Therefore, the intermediate chip 30 and the circuit chip 20 may be electrically connected to each other through the penetration vias 2840.

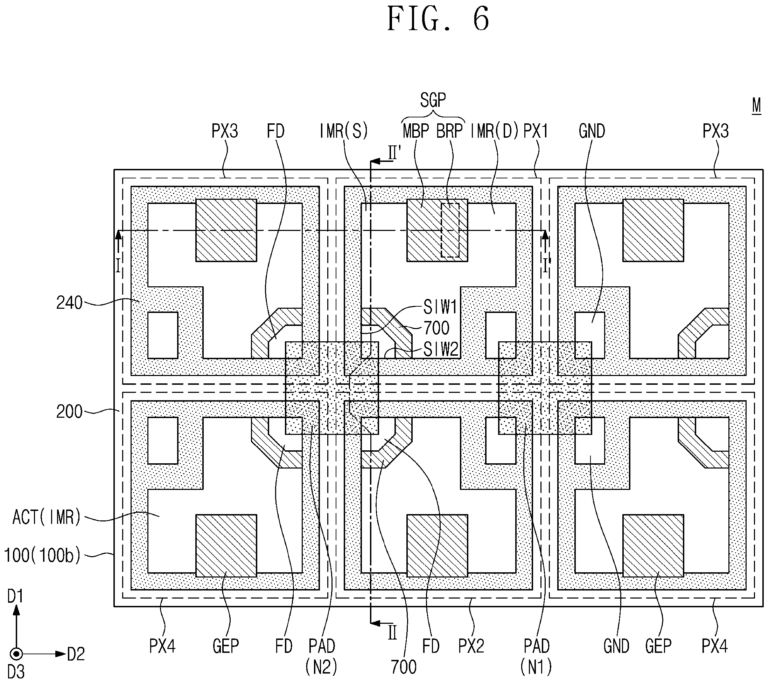

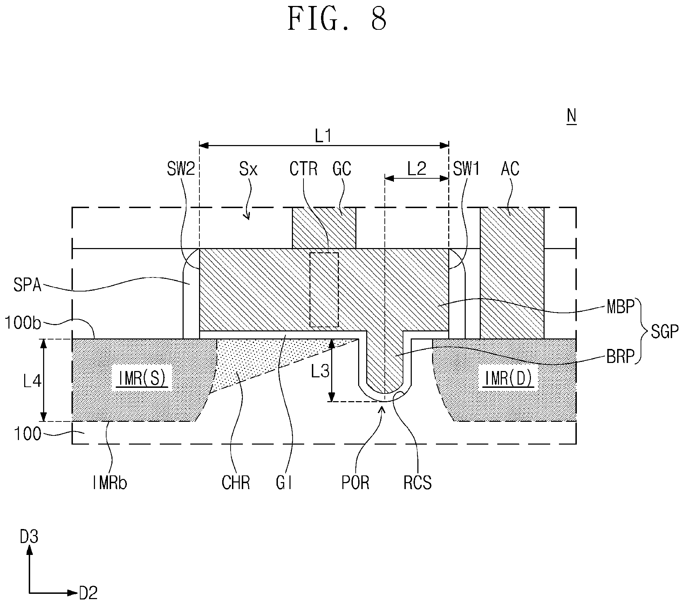

FIG. 6 is a plan view illustrating a portion 'M' of FIG. 2 to describe pixels in an image sensor according to an embodiment of the inventive concept. FIG. 7A is a sectional view taken along a line I-I' of FIG. 6. FIG. 7B is a sectional view taken along a line II-II' of FIG. 6. FIG. 8 is an enlarged sectional view illustrating a portion 'N' of FIG. 7A. For concise description, an element previously described with reference to FIGS. 1 to 3 and which may have the same structure and/or perform the same function as in FIGS. 1 to 3 may be identified by the same reference number without repeating an overlapping description thereof.

Referring to FIGS. 6, 7A, and 7B, an image sensor according to an embodiment of the inventive concept may include a plurality of pixel regions (e.g., first to fourth pixel regions PX1 to PX4). In detail, the first and second pixel regions PX1 and PX2 may be disposed to be adjacent to each other in the first direction D1. The third and fourth pixel regions PX3 and PX4 may be disposed to be adjacent to each other in the first direction D1. The third pixel regions PX3 may be respectively disposed at both sides of the first pixel region PX1. In other words, the first pixel region PX1 may be interposed between the third pixel regions PX3. The fourth pixel regions PX4 may be respectively disposed at both sides of the second pixel region PX2. In other words, the second pixel region PX2 may be interposed between the fourth pixel regions PX4.

The first substrate 100 may include a first or rear surface 100a and a second or front surface 100b. The isolation pattern 200 may be provided to penetrate the first substrate 100 and to define the first to fourth pixel regions PX1 to PX4. The isolation pattern 200 may include the first isolation pattern 210, the second isolation pattern 220, and an insulating pattern 230.

The first isolation pattern 210 may be provided on a side surface of the first trench 201. The first isolation pattern 210 may be formed of or include, for example, at least one silicon-based insulating material (e.g., silicon nitride, silicon oxide, and/or silicon oxynitride) and/or at least one high-k dielectric material (e.g., hafnium oxide and/or aluminum oxide). As another example, the first isolation pattern 210 may include a plurality of layers, at least two of which are formed of or include different materials from each other. The first isolation pattern 210 may have a refractive index lower than that of the first substrate 100. Accordingly, it may be possible to prevent or suppress a cross-talk phenomenon between the pixel regions PX of the first substrate 100.

The second isolation pattern 220 may be provided in the first isolation pattern 210. The first isolation pattern 210 may be interposed between the second isolation pattern 220 and the first substrate 100. The second isolation pattern 220 may be spaced apart from the first substrate 100 by the first isolation pattern 210. Thus, during an operation of the image sensor, the second isolation pattern 220 may be electrically separated from the first substrate 100. The second isolation pattern 220 may be formed of or include at least one conductive material (e.g., doped polysilicon). The second isolation pattern 220 may contain impurities of the first or second conductivity type.

The insulating pattern 230 may be provided on the second isolation pattern 220. A top surface of the insulating pattern 230 may be coplanar with the second surface 100b of the first substrate 100. The insulating pattern 230 may be formed of or include at least one silicon-based insulating material (e.g., silicon oxide).

The contact plug 960 described with reference to FIG. 3 may be electrically connected to the second isolation pattern 220 through the first conductive pattern 911. A negative bias voltage may be applied to the second isolation pattern 220 through the contact plug 960. Positive charges, which are produced in the pixel regions PX1 to PX4, may be removed through the second isolation pattern 220 surrounding the pixel regions PX1 to PX4. Thus, it may be possible to improve a dark current property of the image sensor.

The photoelectric conversion region PD may be provided in each of the pixel regions PX1 to PX4. The photoelectric conversion region PD may include a first region adjacent to the first surface 100a and a second region adjacent to the second surface 100b. There may be a difference in impurity concentration between the first and second regions of the photoelectric conversion region PD. In this case, the photoelectric conversion region PD may have a non-vanishing potential gradient between the first and second surfaces 100a and 100b of the first substrate 100.

The first substrate 100 and the photoelectric conversion region PD may constitute a photodiode. For example, the first substrate 100 of the first conductivity type (p-type) and the photoelectric conversion region PD of the second conductivity type (n-type) may form a p-n junction serving as a photodiode. An amount of photocharges, which are produced and accumulated in the photoelectric conversion region PD of the photodiode, may be proportional to an intensity of an incident light.

The device isolation pattern 240 may be provided at the second surface 100b of the first substrate 100. The device isolation pattern 240 may define the ground region GND, the floating diffusion region FD, and an active region ACT (e.g., FIG. 6) in each of the pixel regions PX1 to PX4. The active region ACT may include the impurity regions IMR. In the present embodiment, the ground region GND may be spaced apart from the floating diffusion region FD and the active region ACT by the device isolation pattern 240 (e.g., see FIG. 6). For example, the ground region GND may have an island shape that is enclosed by the device isolation pattern 240.

The isolation pattern 200 and the device isolation pattern 240 may constitute an isolation structure. The pixel regions PX1 to PX4, the ground regions GND, the floating diffusion regions FD, and the active regions ACT may be defined by the isolation structure.

At least one gate pattern GEP may be provided on the active region ACT. The active region ACT and the gate pattern GEP may constitute at least one of the conversion gain transistor Cx, the reset transistor Rx, and the selection transistor Ax described with reference to FIG. 1. In an embodiment, a source follower gate pattern SGP may be provided on the active region ACT of the first pixel region PX1. The active region ACT of the first pixel region PX1 and the source follower gate pattern SGP may constitute the source follower transistor Sx described with reference to FIG. 1.

The gapfill gate pattern 700 may be provided between the active region ACT and the floating diffusion region FD. Spacers SPA may be provided on opposite side surfaces of the gapfill gate pattern 700. The spacers SPA may be formed of or include at least one silicon-based insulating material (e.g., silicon oxide, silicon nitride, and/or silicon oxynitride).

In an embodiment, the floating diffusion region FD of the first pixel region PX1 may be defined by the device isolation pattern 240. When viewed in a plan view, referring to FIG. 6, the gapfill gate pattern 700 of the first pixel region PX1 may extend from a first side surface SIW1 of the device isolation pattern 240 to a second side surface SIW2. Thus, the floating diffusion region FD of the first pixel region PX1 may have an island shape, which is enclosed by the first and second side surfaces SIW1 and SIW2 of the device isolation pattern 240 and the gapfill gate pattern 700.

The pad PAD may be provided on the ground regions GND of the first to fourth pixel regions PX1 to PX4, which are adjacent to each other. When viewed in a plan view, the pad PAD may have a tetragonal, rectangular, or square shape. Corners of the pad PAD may contact the ground regions GND of the first to fourth pixel regions PX1 to PX4, respectively. The pad PAD may connect four adjacent ones of the ground regions GND to each other. The pad PAD, which is connected in common to the four ground regions GND, may include the first node N1 of FIG. 1, which is used to apply the ground voltage VSS to them.

The pad PAD may be provided on the floating diffusion regions FD of the first to fourth pixel regions PX1 to PX4, which are adjacent to each other. The corners of the pad PAD may contact the floating diffusion regions FD of the first to fourth pixel regions PX1 to PX4, respectively. The pad PAD may connect four adjacent ones of the floating diffusion regions FD to each other. The pad PAD, which is connected in common to the four floating diffusion regions FD, may include the second node N2 of FIG. 1.

The spacer SPA may be provided on side surfaces of each of the pads PAD. In the present embodiment, the pads PAD may be formed when the gapfill gate pattern 700, the source follower gate pattern SGP, and the gate pattern GEP are formed. Thus, first and second pads PAD1 and PAD2 may be formed of or include the same conductive material (e.g., doped polysilicon) as the gapfill gate pattern 700, the source follower gate pattern SGP, and the gate pattern GEP.

The first interconnection layer 800 may be provided on the second surface 100b of the first substrate 100. The first interconnection layer 800 may include a plurality of metal layers, which are sequentially stacked. For example, a first metal layer may include first interconnection lines 831, and a second metal layer on the first metal layer may include second interconnection lines 832. A via VI may be provided between the second interconnection line 832 and the first interconnection line 831. The first metal layer and the second metal layer may be connected to each other through the via VI.

A contact AC may be provided between the first interconnection line 831 and the pad PAD. The first interconnection line 831 may be used to commonly apply the ground voltage VSS to the ground regions GND of the first to fourth pixel regions PX1 to PX4 through the contact AC and the pad PAD. The first interconnection line 831 may be connected in common to the floating diffusion regions FD of the first to fourth pixel regions PX1 to PX4 through the contact AC and the pad PAD.

Referring to FIG. 7A, the first interconnection line 831 may be connected to the impurity region IMR of the active region ACT through the contact AC. In an embodiment, the source follower gate pattern SGP may be electrically connected to the first interconnection line 831, which is connected in common to the floating diffusion regions FD, through a gate contact GC.

The insulating layer 400 may be provided on the first surface 100a of the first substrate 100. The fence pattern 300 may be provided on the insulating layer 400. The color filters CF may be provided between portions of the fence pattern 300 arranged in a grid shape. The micro-lens layer 500 including the micro lenses 510 may be provided on the color filters CF. The micro lenses 510 may cover the first to fourth pixel regions PX1 to PX4, respectively.

The source follower transistor Sx according to an embodiment of the inventive concept will be described in more detail with reference to FIGS. 7A and 8. The source follower gate pattern SGP may have a similar structure to the gapfill gate pattern 700 described above.

The source follower gate pattern SGP may include a body portion MBP, which is provided on the second surface 100b (e.g., above the second surface 100b), and a buried portion BRP, which extends (e.g., protrudes) from the body portion MBP into the first substrate 100, and is thus formed in the first substrate 100 below the second surface 100b. For example, the body portion MBP may be above the substrate 100 and not in the substrate 100 (e.g., not below a top surface of the substrate, e.g. the second surface 100b), and the buried portion BRP may be below the top surface of the substrate 100 (e.g. the second surface 100b) and in the substrate 100. A recess region RCS may be defined in an upper portion of the first substrate 100. The recess region RCS may be recessed from the second surface 100b toward the first surface 100a, and may be a region where the material that forms the first substrate (e.g., crystalline silicon in one embodiment, is absent). The buried portion BRP may be provided in the recess region RCS of the first substrate 100. The buried portion BRP may be buried in the active region ACT.

The source follower gate pattern SGP may include a first side surface SW1 and a second side surface SW2, which are opposite to each other. The impurity regions IMR may be respectively provided at both sides (e.g., opposite side surfaces) of the source follower gate pattern SGP. The impurity regions IMR may include a drain region D adjacent to the first side surface SW1 and a source region S adjacent to the second side surface SW2. For example, the drain region D may be electrically connected to a voltage source (e.g., V_{DD}, as shown in FIG. 1), and the source region S may be electrically connected to an output node (e.g., V_{OUT}, through selection transistor Ax).

The active region ACT between the source region S and the drain region D may include a first impurity (e.g., boron (B)). The impurity region IMR may include a second impurity (e.g., phosphorus (P)). A concentration of the second impurity in the impurity region IMR may range from about 1.0E20 atoms/cm³ to about 1.0E21 atoms/cm³. In an embodiment, a bottom IMRb, or an outer boundary, of the impurity region IMR may be defined as a point or border, at which the concentration of the second impurity is about 1.0E20 atoms/cm³ or first drops below 1.0E20 atoms/cm³. Terms such as "about" or "approximately" may reflect amounts, sizes, orientations, or layouts that vary only in a small relative manner, and/or in a way that does not significantly alter the operation, functionality, or structure of certain elements.

A gate insulating layer GI may be provided between the source follower gate pattern SGP and the active region ACT. As an example, the gate insulating layer GI may be formed of or include, for example, at least one silicon-based insulating material (e.g., silicon oxide, silicon nitride, and/or silicon oxynitride) and/or at least one high-k dielectric material (e.g., hafnium oxide and/or aluminum oxide). The gate insulating layer GI may be formed to cover not only the second surface 100b but also the recess region RCS.

The buried portion BRP may be offset from a center of the source follower gate pattern SGP in a direction toward the drain region D. For example, the source follower gate pattern SGP may have an asymmetric structure including a buried portion that is between a source region and a drain region of a transistor, and is closer to the drain region than it is to the source region. The buried portion BRP may have a symmetrical structure in of itself, such as a pillar shape with symmetrical opposite sidewalls, and the body portion MBP may also have a symmetrical structure alone, but together the source follower gate pattern SGP as a whole has a non-symmetrical shape, for example as seen along the D3/D2 plane from the D1 direction.

In an embodiment, the buried portion BRP may be offset from a center region CTR of the body portion MBP in the second direction D2. The center region CTR of the body portion MBP may not overlap the buried portion BRP. When viewed in a plan view, the buried portion BRP may be disposed between the center region CTR of the body portion MBP and the drain region D.

In detail, a gate length of the source follower gate pattern SGP may be a first length L1. The first length L1 may be a length between the first side surface SW1 and the second side surface SW2 in the second direction D2. A length between a center of the buried portion BRP and the first side surface SW1 may be a second length L2. The second length L2 may be smaller than the first length L1 and for example may be less than 0.5 times the first length L1. For example, the second length L2 may be 0.1 to 0.5 times the first length L1. More specifically, the second length L2 may be 0.1 to 0.4 times the first length L1. Therefore, the buried portion BRP may be disposed to be closer to the drain region D than to the source region S.

A depth of the recess region RCS, in which the buried portion BRP is provided, may be a third length L3. The third length L3 may be a length between a bottom of the recess region RCS and the second surface 100b in the third direction D3. A bottom of the recess region RCS may be higher than the bottom IMRb of the impurity region IMR, for example, in relation to the first surface 100a of the substrate 100. For example, the third length L3 may be smaller than a thickness of the impurity region IMR (i.e., a fourth length L4), so that a bottom-most boundary of the impurity region IMR (e.g., source region or drain region) is lower than a bottom-most surface of the recess region RCS or buried region BRP. In the case where the bottom of the recess region RCS is placed at a level lower than the bottom IMRb of the impurity region IMR, the concentration of the first impurity (e.g., B) near the recess region RCS may become excessively high, which may lead to a deterioration in a RTS noise property of the source follower transistor Sx. In the present context, a "higher" position relates to a position further along the third direction D3 than a "lower" position. The third direction D3 may run from the first surface 100a towards (and beyond) the second surface 100b.

In the present embodiment, the second length L2 may be smaller than the third length L3. A ratio L3/L2 of the third length L3 to the second length L2 may be in range from 1.1 to 2. With regard to the buried portion BRP of the source follower gate pattern SGP, if the ratio L3/L2 is within the above range, it may be possible to increase an effective channel length of the source follower transistor Sx and to improve the RTS noise property.

The source follower transistor Sx may be operated in a saturation mode. In the case where the source follower transistor Sx is operated in the saturation mode, a channel CHR may be extended from the source region S toward the buried portion BRP. A depletion region may be formed around the drain region D. A pinch-off region POR may be formed near the drain region D.

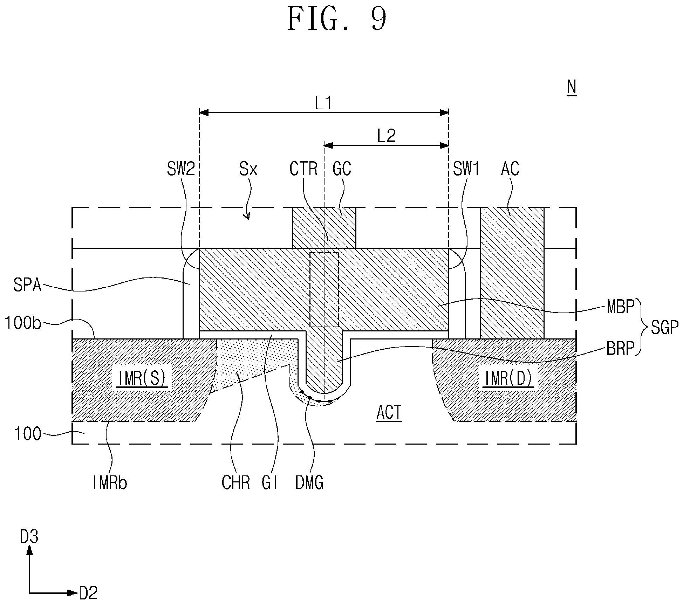

FIG. 9 is an enlarged sectional view illustrating the portion 'N' of FIG. 7A to describe a source follower transistor according to a comparative example. Referring to FIG. 9, the buried portion BRP may be disposed near a center of the source follower gate pattern SGP. For example, the second length L2 may be about 0.5 times the first length L1. In the comparative example, the source follower gate pattern SGP may have a symmetric structure.

In a process of forming the recess region RCS to define the buried portion BRP, an etch damage DMG may occur on an inner surface of the recess region RCS. In addition, since the recess region RCS has a finite depth from the second surface 100b, a concentration of the first impurity may be relatively high near the recess region RCS.

When the source follower transistor Sx is operated in a saturation mode, the channel CHR may be formed along the recess region RCS. Here, although the effective channel length of the transistor is increased, a noise issue may increase, due to the etch damage DMG and the first impurities (e.g., B) of the high concentration near the recess region RCS.

By contrast, according to an embodiment of FIG. 8, since the buried portion BRP is disposed to be close to the drain region D, the buried portion BRP may be provided in a depletion region. Thus, a pinch-off region POR may be formed near the recess region RCS. Accordingly, the channel CHR may not be formed near the recess region RCS. Thus, in the source follower transistor Sx according to an embodiment of the inventive concept, it may be possible to prevent the noise issue from increasing, even when the etch damage DMG and the first impurities of the high concentration are present near the recess region RCS.

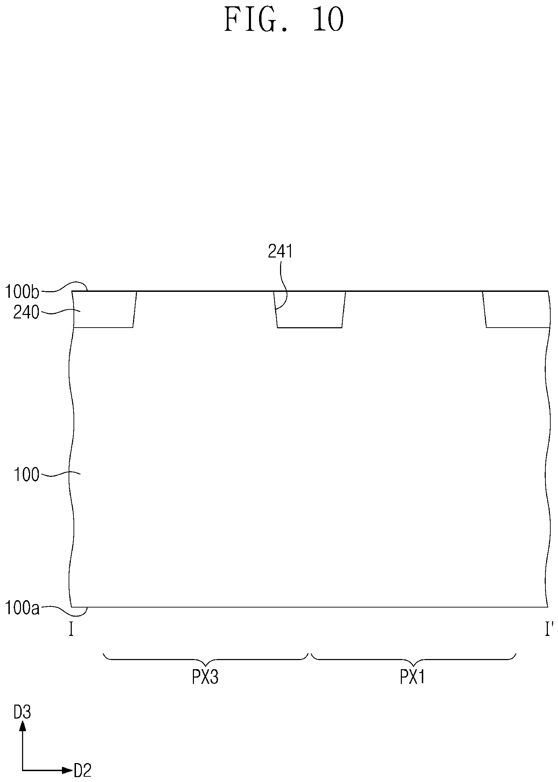

FIGS. 10 to 14 are sectional views illustrating a method of fabricating an image sensor according to an embodiment of the inventive concept. FIGS. 10 to 14 are sectional views, each of which is taken along a line I-I' of FIG. 6.

Referring to FIGS. 6 and 10, the first substrate 100 having the first and second surfaces 100a and 100b, which are opposite to each other, is provided. The first substrate 100 may have a first conductivity type (e.g., p-type) or may be doped with first impurities (e.g., B) to have the first conductivity type.

The device isolation pattern 240 is formed on the second surface 100b of the first substrate 100. In detail, the second trench 241 may be formed by patterning the second surface 100b of the first substrate 100. An insulating layer may be formed to fill the second trench 241. The device isolation pattern 240 may be formed by planarizing the insulating layer to expose the second surface 100b of the first substrate 100. In an embodiment, the insulating layer may be formed of or include at least one of silicon oxide, silicon nitride, and/or silicon oxynitride.

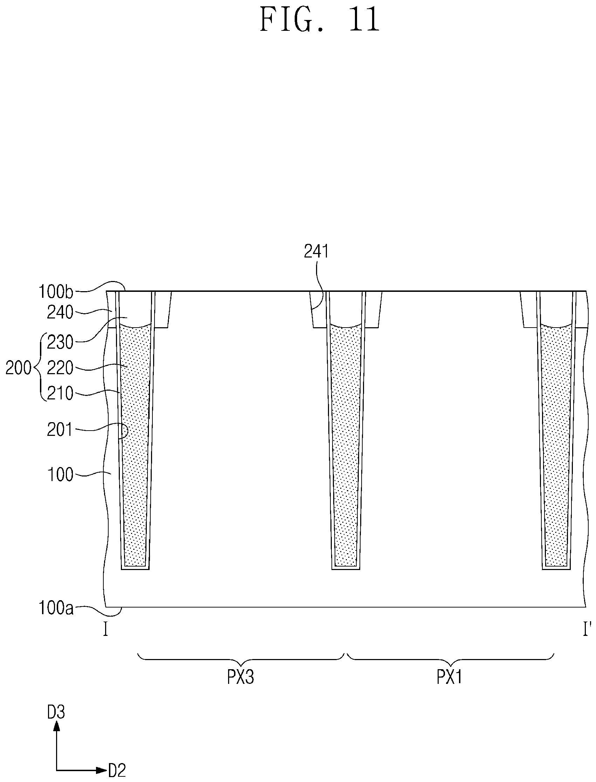

Referring to FIGS. 6 and 11, the isolation pattern 200 is formed on the second surface 100b of the first substrate 100. In detail, the second surface 100b of the first substrate 100 may be patterned to form the first trench 201 defining the pixel regions PX1 to PX4. When viewed in a plan view, the first trench 201 may be formed to have a grid shape.

A portion of the device isolation pattern 240 may be etched during the formation of the first trench 201. The first trench 201 may be formed to penetrate a portion of the device isolation pattern 240.

The first trench 201 may extend from the second surface 100b toward the first surface 100a. As an example, a width of the first trench 201 may gradually decrease as a distance from the second surface 100b increases in a direction toward the first surface 100a. The first trench 201 may be deeper than the second trench 241, which is filled with the device isolation pattern 240. A bottom of the first trench 201 may be vertically spaced apart from the first surface 100a.

The first isolation pattern 210 may be formed to partially fill the first trench 201. The formation of the first isolation pattern 210 may include conformally forming an insulating layer on the second surface 100b of the first substrate 100. The first isolation pattern 210 may cover an inner side surface and a bottom surface of the first trench 201. In an embodiment, the insulating layer may be formed of or include at least one silicon-based insulating material and/or at least one high-k dielectric material.

The second isolation pattern 220 may be formed on the first isolation pattern 210. The formation of the second isolation pattern 220 may include forming a conductive layer to fill the first trench 201 and performing an etch-back process on the conductive layer. The second isolation pattern 220 may be formed to fill a lower portion of the first trench 201. In other words, the second isolation pattern 220 may be formed to fill the remaining portion of the first trench 201, except for an upper portion thereof. A top surface of the second isolation pattern 220 may be lower than the second surface 100b of the first substrate 100. As an example, the conductive layer may be formed of or include doped polysilicon.

The insulating pattern 230 may be formed on the second isolation pattern 220. The formation of the insulating pattern 230 may include forming an insulating layer to fill the upper portion of the first trench 201. As an example, the insulating layer may be formed of or include at least one silicon-based insulating material. Next, the isolation pattern 200 may be formed by performing a planarization process on the second surface 100b of the first substrate 100 to expose the second surface 100b.

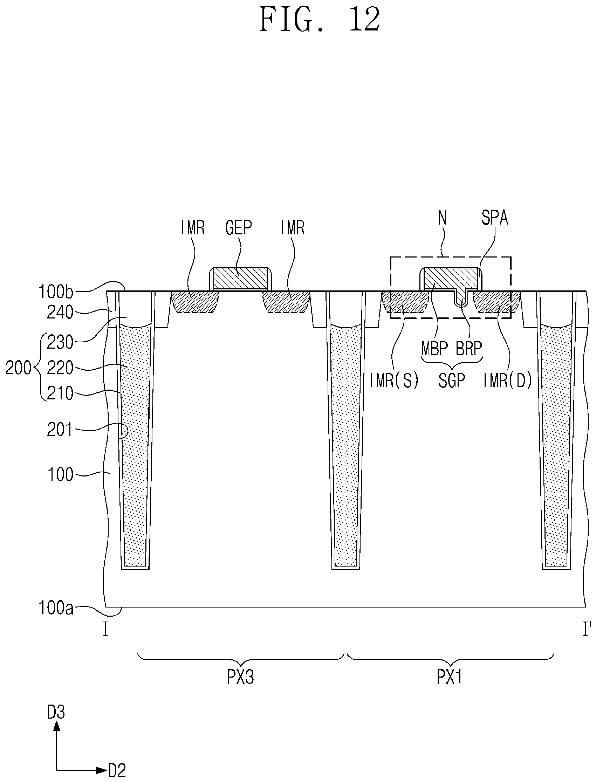

Referring to FIGS. 6 and 12, the active region ACT including the impurity regions IMR may be formed in each of the pixel regions PX1 to PX4. The source follower gate pattern SGP may be formed on the active region ACT. The gate pattern GEP may be formed on the active region ACT. The spacer SPA may be formed on a side surface of each of the source follower gate pattern SGP and the gate pattern GEP.

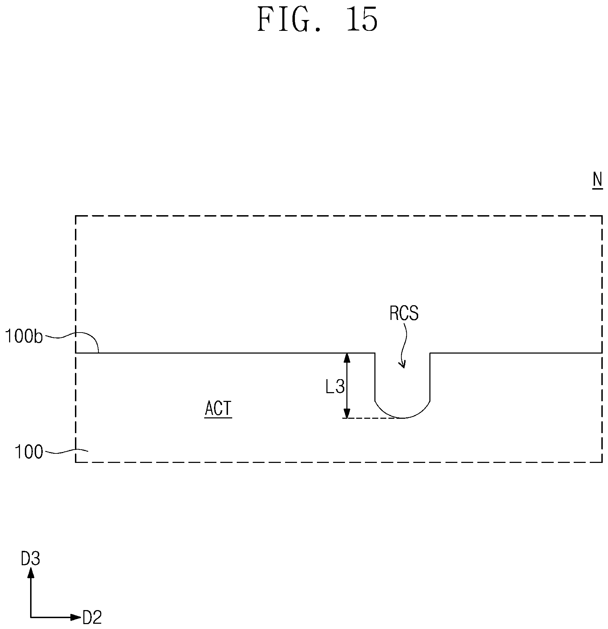

FIGS. 15 to 18 are sectional views illustrating a process of forming a portion N of FIG. 12. Referring to FIG. 15, the recess region RCS is formed in an upper portion of the active region ACT. The recess region RCS may be formed to have a depth, which is given as the third length L3, from the second surface 100b of the first substrate 100. The formation of the recess region RCS may include forming a mask pattern on the second surface 100b and anisotropically etching the first substrate 100 using the mask pattern as an etch mask. As a result of the anisotropic etching process, an etch damage DMG (e.g., see FIG. 9) may be formed on an inner surface of the recess region RCS.

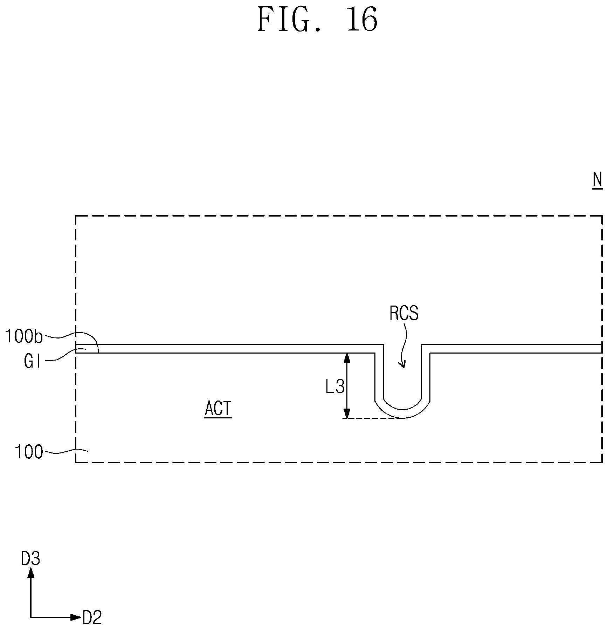

Referring to FIG. 16, the gate insulating layer GI is conformally formed on the second surface 100b and the inner surface of the recess region RCS. The formation of the gate insulating layer GI may be formed by a deposition process (e.g., CVD or ALD). The gate insulating layer GI may be formed of or include, for example, at least one silicon-based insulating material (e.g., silicon oxide, silicon nitride, and/or silicon oxynitride) and/or at least one high-k dielectric material (e.g., hafnium oxide and/or aluminum oxide). The gate insulating layer GI may partially fill the recess region RCS.

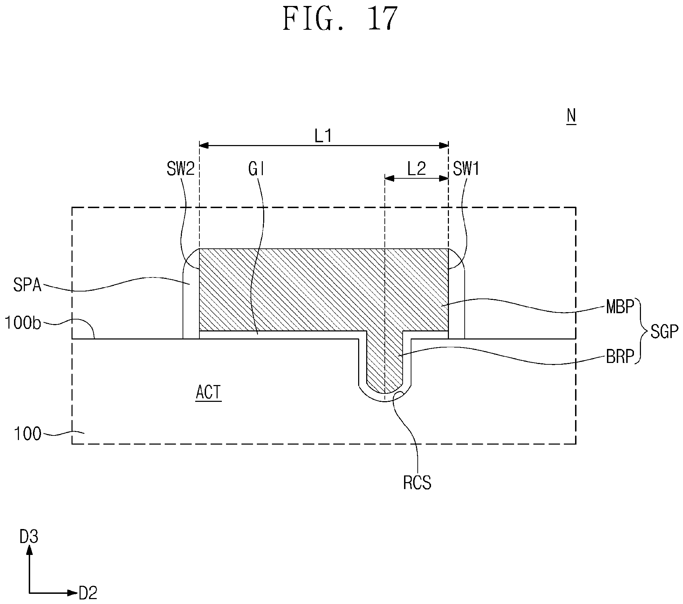

Referring to FIG. 17, the source follower gate pattern SGP is formed on the gate insulating layer GI. In detail, a conductive layer may be formed on the gate insulating layer GI. In an embodiment, the conductive layer may be formed of or include doped polysilicon. The conductive layer may fill the recess region RCS. The conductive layer may be patterned to form the source follower gate pattern SGP. The source follower gate pattern SGP may include the body portion MBP provided on the second surface 100b and the buried portion BRP in the recess region RCS.

The formation of the source follower gate pattern SGP may be performed such that the second length L2 between the first side surface SW1 and a center of the buried portion BRP is 0.1 to 0.5 times the gate length L1. Thus, the buried portion BRP may be formed to be close to the drain region D, which will be described below.

The spacer SPA may be formed on the opposite side surfaces SW1 and SW2 of the source follower gate pattern SGP. The formation of the spacer SPA may include forming a spacer layer on the source follower gate pattern SGP and performing an anisotropic etching process on the spacer layer.

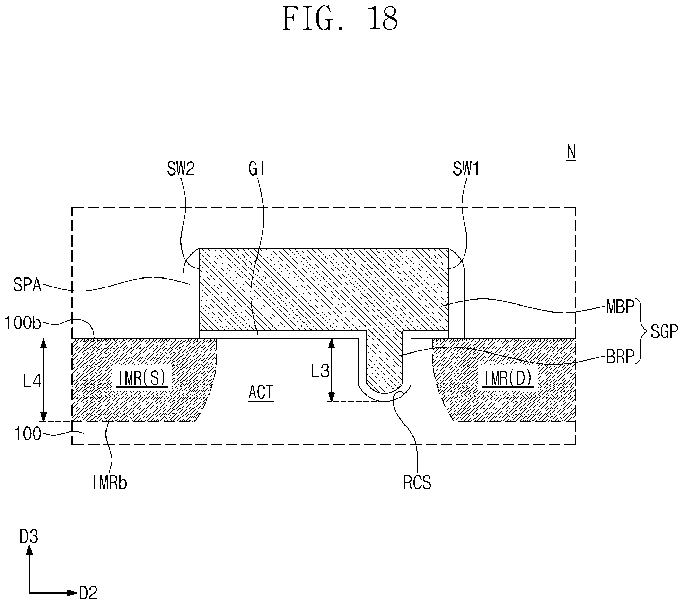

Referring to FIG. 18, an impurity doping process, in which the source follower gate pattern SGP is used as a mask, may be performed on the first substrate 100. Thus, the impurity regions IMR may be formed at both sides of the source follower gate pattern SGP. The impurity region IMR may contain second impurities (e.g., P). The impurity region IMR may be formed to have a thickness of the fourth length L4. The fourth length L4 may be larger than the third length L3. As described above, the buried portion BRP may be adjacent to the drain region D of the impurity regions IMR.

Although not shown, the gapfill gate pattern 700 and the gate pattern GEP may be formed simultaneously using the same process as the source follower gate pattern SGP.

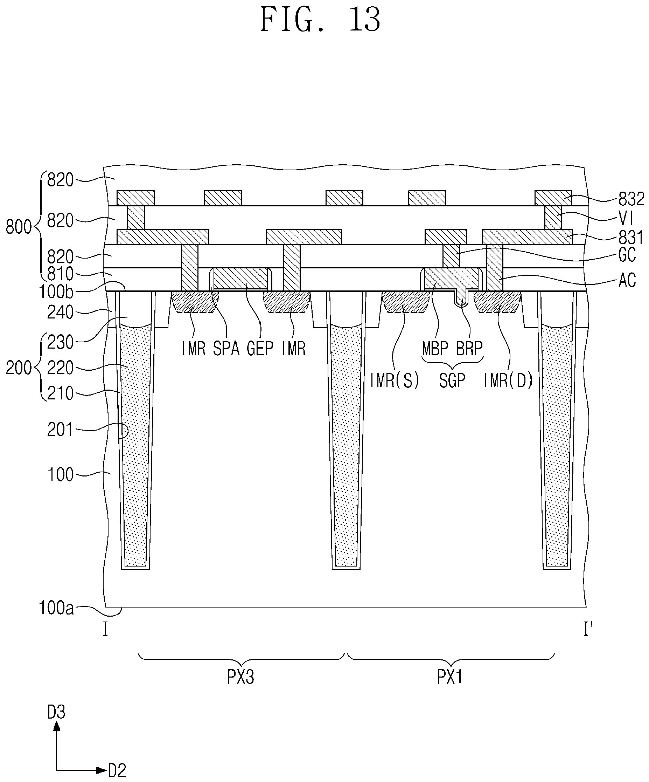

Referring to FIGS. 6 and 13, the first interconnection layer 800 may be formed on the second surface 100b of the first substrate 100. The formation of the first interconnection layer 800 may include stacking a plurality of metal layers.

In detail, the contact AC may be formed on the impurity region IMR. The gate contact GC may be formed on the source follower gate pattern SGP. The first interconnection lines 831 may be formed on the contact AC and the gate contact GC, respectively. Vias VI may be formed on the first interconnection lines 831. The second interconnection lines 832 may be formed on the vias VI.

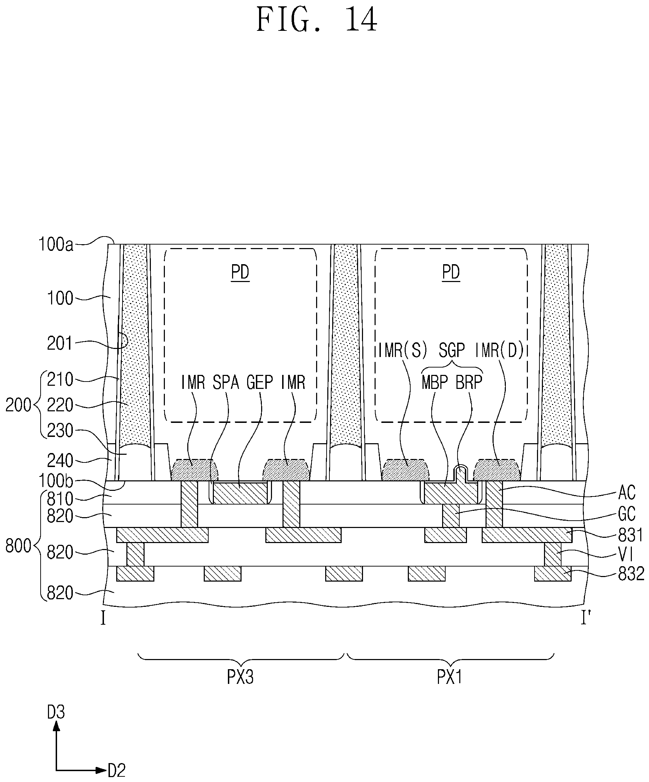

Referring to FIGS. 6 and 14, a planarization process may be performed on the first surface 100a of the first substrate 100 to expose the second isolation pattern 220 of the isolation pattern 200. Thus, a thickness of the first substrate 100 may be reduced. The isolation pattern 200 may be formed to have a depth that is substantially equal to the thickness of the first substrate 100. The photoelectric conversion regions PD may be formed by doping portions of the pixel regions PX1 to PX4 with impurities. The photoelectric conversion regions PD may be formed to have a second conductivity type (e.g., n-type).

Referring back to FIGS. 6, 7A, and 7B, the insulating layer 400 may be formed on the first surface 100a of the first substrate 100. The fence pattern 300 of a grid shape may be formed on the insulating layer 400. The color filters CF may be formed on the fence pattern 300. The micro-lens layer 500 may be formed on the color filters CF.

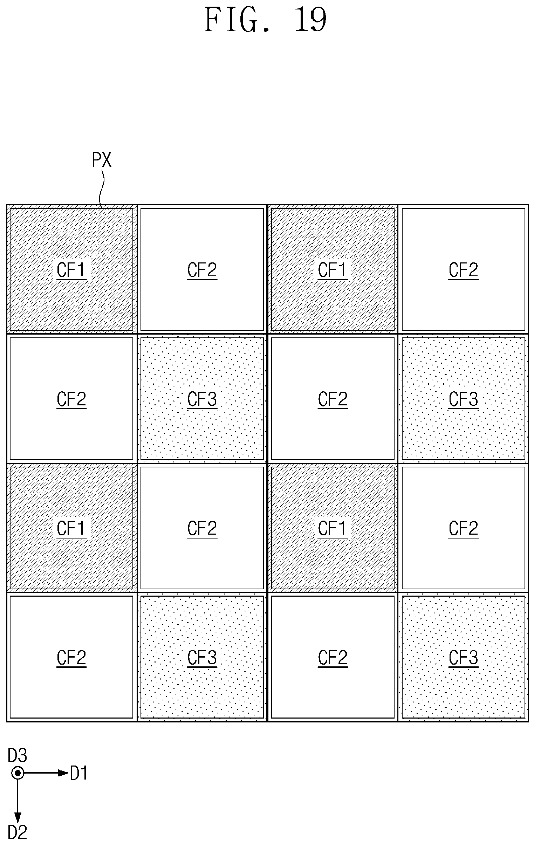

FIGS. 19, 20, and 21 are plan views illustrating some of possible arrangements of color filters in an image sensor according to an embodiment of the inventive concept.

Referring to FIG. 19, the color filters CF may include first to third color filters CF1, CF2, and CF3, which are arranged in a 2x2 matrix. The 2x2 color filters CF may include one first color filter CF1, two second color filters CF2, and one third color filter CF3. The 2x2 color filters CF may be two-dimensionally arranged to form a Bayer pattern. For example, the first color filter CF1 may be a red color filter, the second color filter CF2 may be a green color filter, and the third color filter CF3 may be a blue color filter.

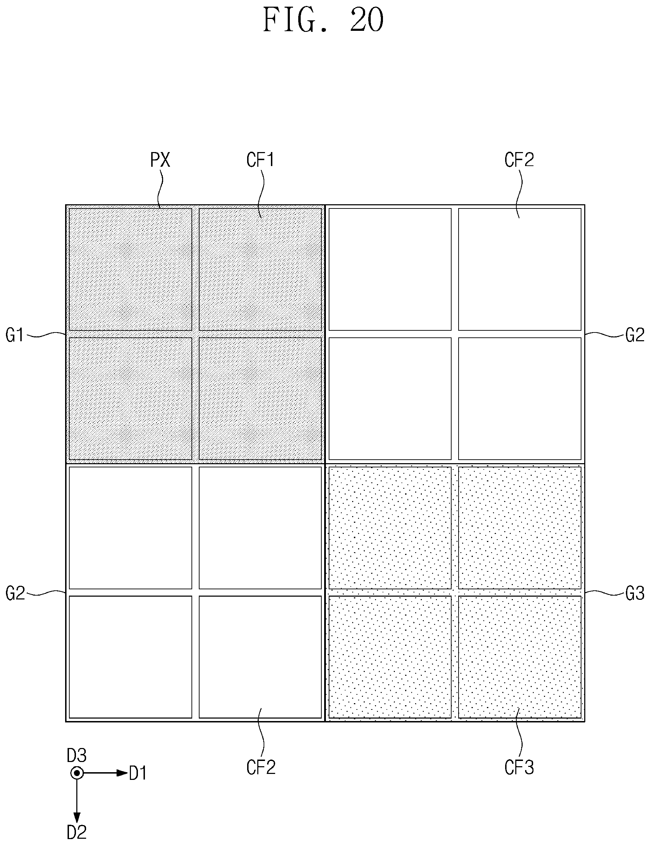

Referring to FIG. 20, first to third pixel groups G1, G2, and G3 may be provided. The first pixel group G1 may be configured to sense a first light, the second pixel groups G2 may be configured to sense a second light, and the third pixel group G3 may be configured to sense a third light.

Each of the first to third pixel groups G1, G2, and G3 may include NxM pixel regions PX, which are arranged in an NxM matrix. Here, each of N and M are independently an integer of 1 or greater. The image sensor according to the present embodiment may have a pixel arrangement in a 2x2 Tetra structure (i.e., both the numbers N and M are 2).

The first pixel group G1 may include the first color filter CF1, each of the second pixel groups G2 may include the second color filter CF2, and the third pixel group G3 may include the third color filter CF3. For example, the first color filter CF1 may be a red color filter, the second color filter CF2 may be a green color filter, and the third color filter CF3 may be a blue color filter.

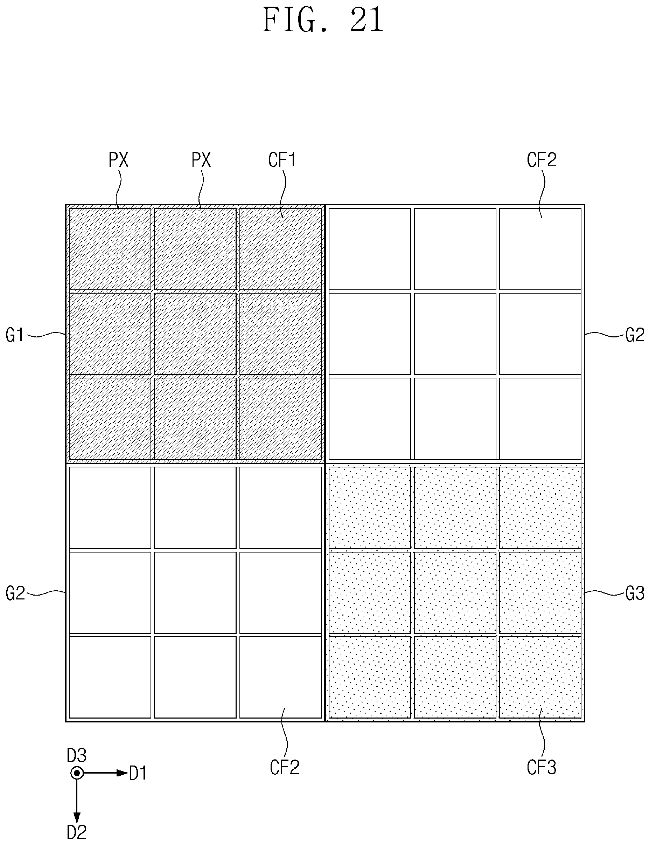

Referring to FIG. 21, each of the first to third pixel groups G1, G2, and G3 may include NxM pixel regions PX, which are arranged in a NxM matrix. In the present embodiment, the image sensor may have a pixel arrangement in 3x3 Nona structure (i.e., both the numbers N and M are 3).

According to an embodiment of the inventive concept, an image sensor may include a source follower transistor having an asymmetric structure. A buried portion of the source follower transistor may be disposed to be closer to a drain region than to a source region, it may be possible to increase an effective channel length and to suppress occurrence of a noise signal. Thus, it may be possible to improve performance of the image sensor according to an embodiment of the inventive concept.

While example embodiments of the inventive concept have been particularly shown and described, it will be understood by one of ordinary skill in the art that variations in form and detail may be made therein without departing from the scope of the attached claims.

Spatially relative terms, such as "beneath," "below," "lower," "above," "upper," "top," "bottom," and the like, may be used herein for ease of description to describe positional relationships, such as illustrated in the figures, for example. It will be understood that the spatially relative terms encompass different orientations of the device in addition to the orientation depicted in the figures.

## Claims

1. An image sensor, comprising:
a substrate including an active region, the active region comprising a source region and a drain region;
a source follower gate pattern on the active region, the drain region being adjacent to a first side surface of the source follower gate pattern, the source region being adjacent to a second side surface of the source follower gate pattern; and
a gate insulating layer between the active region and the source follower gate pattern,
wherein:
an upper portion of the active region includes a recess region,
the source follower gate pattern comprises a body portion on the active region and a buried portion provided in the recess region and protruding below the body portion,
a distance between the first and second side surfaces is a first length,
a distance between a center of the buried portion and the first side surface is a second length, and
the second length is greater than or equal to 0.1 times the first length, and is less than 0.5 times the first length.

2. The image sensor of claim 1, wherein a depth of the recess region is a third length, and the second length is smaller than the third length.

3. The image sensor of claim 2, wherein a ratio of the third length to the second length is within a range from 1.1 to 2.

4. The image sensor of claim 2 or claim 3, wherein a thickness of each of the source and drain regions is a fourth length, and
the third length is smaller than the fourth length.

5. The image sensor of any preceding claim, wherein:
the substrate has a first surface and a second surface, which are opposite to each other,
the active region is adjacent to the second surface, and
the substrate further comprises a photoelectric conversion region provided therein.

6. The image sensor of claim 5, further comprising:
a color filter on the first surface of the substrate; and
a micro lens on the color filter.

7. The image sensor of any preceding claim, wherein the buried portion is disposed to be closer to the drain region than to the source region.

8. The image sensor of any preceding claim, further comprising a gapfill gate pattern on the active region,
wherein:
the active region further comprises a floating diffusion region adjacent to the gapfill gate pattern,
the gapfill gate pattern comprises a first portion on the active region and a second portion buried in the substrate, and
a bottom surface of the second portion is lower than a bottom surface of the buried portion.

9. The image sensor of any preceding claim, further comprising a plurality of metal layers stacked on the substrate,
wherein an interconnection line in the metal layers is electrically connected to the source follower gate pattern through a contact.

10. The image sensor of any preceding claim, wherein a pinch-off region is formed near the recess region.

11. The image sensor of any preceding claim, wherein a bottom-most boundary of the drain region is lower than a bottom-most surface of the buried portion.

12. The image sensor of any preceding claim, wherein:
the substrate includes a first surface and a second surface, which are opposite to each other;
the image sensor comprises:
an isolation pattern provided in the substrate to define a pixel region, the pixel region comprising the active region adjacent to the second surface;
a color filter on the first surface of the substrate;
a micro lens on the color filter;
a device isolation pattern provided on the second surface of the substrate to define the active region; and
an interconnection line provided on the source follower gate pattern and electrically connected to the source follower gate pattern.

13. The image sensor of claim 12, wherein the pixel region further comprises a photoelectric conversion region provided in the substrate.

14. The image sensor of claim 12 or claim 13, wherein:
the buried portion is formed symmetrically with respect to a center of the buried portion.
